# EUROPEAN PATENT SPECIFICATION

(11) **EP 4 465 771 B1**
(45) Date of publication and mention of the grant of the patent: **28.01.2026**
(21) Application number: 24714131.0
(22) Date of filing: 07.03.2024
(51) Int. Cl.: H05K 1/02, H05K 1/14, H05K 3/46, H04M 1/02, G06F 1/16

(54) **ELECTRONIC DEVICE COMPRISING MULTILAYER FLEXIBLE PRINTED CIRCUIT BOARD**
ELEKTRONISCHE VORRICHTUNG MIT EINER MEHRSCHICHTIGEN FLEXIBLEN LEITERPLATTE
DISPOSITIF ÉLECTRONIQUE COMPRENANT UNE CARTE DE CIRCUIT IMPRIMÉ SOUPLE MULTICOUCHE

(30) Priority: 27.03.2023 KR 20230039866; 12.05.2023 KR 20230061694
(43) Date of publication of application: 20.11.2024
(73) Proprietor: Samsung Electronics Co., Ltd., Suwon-si, Gyeonggi-do 16677 (KR)
(72) Inventor: PARK, Eunsoo, Suwon-si, Gyeonggi-do 16677 (KR); KIM, Doyun, Suwon-si, Gyeonggi-do 16677 (KR); KIM, Yongwoon, Suwon-si, Gyeonggi-do 16677 (KR); WOO, Jonghoon, Suwon-si, Gyeonggi-do 16677 (KR); HAN, Yonggil, Suwon-si, Gyeonggi-do 16677 (KR); LEE, Jinho, Suwon-si, Gyeonggi-do 16677 (KR)
(74) Representative: HGF
(86) International application number: PCT/KR2024/002969
(87) International publication number: WO 2024/205067

(56) References cited:
- EP-A1- 4 300 925
- EP-A1- 4 350 472
- EP-A2- 0 632 685
- WO-A1-2022/203431
- JP-A- 2006 041 044
- JP-U- H0 193 770
- KR-A- 20130 034 787
- KR-A- 20200 021 172
- KR-A- 20210 101 669
- US-A1- 2022 173 048

## Description

### [Technical Field]

The disclosure relates to an electronic device including a multilayer flexible printed circuit board.

### [Background Art]

A foldable electronic device may include a folding area including a hinge device in order to implement a folding operation. The foldable electronic device may include a flexible printed circuit board for electrical connection between internal components thereof, and a portion of the flexible printed circuit board may be disposed in the folding area.

In the foldable electronic device, a flexible printed circuit board may be subjected to stress due to repeated folding operations within a limited space of the folding area. As a radius of curvature of the flexible printed circuit board increases, the stress applied to the flexible printed circuit board may reduce. Therefore, the flexible printed circuit board of the foldable electronic device may be designed to have a determined shape in order to maximize the radius of curvature.

WO2022/203431A1 concerns a foldable electronic device comprising: a hinge structure; a foldable housing including a folding area in which an electronic device is actually folded around a folding axis, the foldable housing including a first housing structure, which includes a first printed circuit board in which a plurality of electronic components are mounted, and a second housing structure, which is connected to the hinge structure, includes a second printed circuit board in which a plurality of electronic components are mounted and is folded with the first housing structure around the hinge structure; a flexible display; and a flexible connection member, which lies across at least a portion of the inside of the first housing structure and at least a portion of the inside of the second housing structure, electrically connects the first printed circuit board and the second printed circuit board through connective end portions arranged on both ends thereof, and includes a wiring for transmitting a communication signal including a radio frequency (RF) signal, wherein an impedance matching unit is mounted on at least one end of the connection member.

EP0632685A2 concerns multi-layer substrates for flexible circuit boards and flexible circuit board assemblies and their methods of manufacture. More particularly multi-layer flexible circuit board substrates are described for attaching components including chips and heat spreaders to form a three-dimensional circuit board assembly.

US2022/173048A1 concerns a semiconductor package device including a flexible carrier, a first chip, a second chip, a first molding layer, a first adhesive layer and a second molding layer. The flexible carrier has a flexible layer and a rigid layer. The flexible layer has a patterned build-up circuit. The rigid layer is connected to a portion surface of the flexible layer. The position that the flexible layer connected to the rigid layer is formed between a first carrying part and a second carrying part. The region of the flexible layer between the first carrying part and the second carrying part without the rigid layer is formed as a first flexible part. The first chip is connected to the first carrying part by flip-chip manner and the second chip is connected to the second carrying part by flip-chip manner. The first molding layer covers the first chip and the second molding layer covers the second chip. The first adhesive layer is connected between the first molding layer and the second carrying part.

EP4350472A1 (published on 10 April 2024) concerns an electronic device including, for example: a first housing, a second housing, a hinge cover, a hinge structure, a display, and a flexible printed circuit board (FPCB) including a rigid portion configured to be disposed on a first cover portion in the folded state, a first flexible portion connected to the rigid portion and configured to be at least partially bent along a second cover portion, and a second flexible portion connected to the rigid portion oppositely to the first flexible portion and configured to be at least partially bent along a third cover portion. The rigid portion is more rigid than the first flexible portion and the second flexible portion.

### [Disclosure of Invention]

### [Technical Problem]

As the space of the folding area of the foldable electronic device reduces, the radius of curvature of the flexible printed circuit board may reduce, and the stress applied to the flexible printed circuit board may increase.

In the foldable electronic device, because a length of the flexible printed circuit board relatively increases (i.e. is relatively greater, because it needs to be able to accommodate the folding and unfolding of the device) compared to a non-foldable electronic device, a path loss of (or along) the flexible printed circuit board may increase.

In the case that all of each layer included in the flexible printed circuit board is bonded, it is difficult for the flexible printed circuit board disposed in the folding area of the foldable electronic device to maintain a determined design shape, and the stress applied to the flexible printed circuit board may increase. In other words, when all layers are bonded together (by bonding each adjacent pair of layers to each other, by suitable bonding means), this may result in the flexible printed circuit board experiencing high stress when the device is repeatedly folded and unfolded.

### [Solution to Problem]

The invention is defined in claim 1. Additional features of the invention are provided in the dependent claims 2 to 14. According to the invention, an electronic device includes a first housing, a second housing, a hinge, and a multilayer flexible printed circuit board. The first housing may be disposed on the first printed circuit board. The second housing may be disposed on the second printed circuit board. The hinge (or hinge device, assembly, module, or structure) rotatably (or foldably) connects the first housing and the second housing with respect to each other (or to each other). The multilayer flexible printed circuit board connects the first printed circuit board and the second printed circuit board (i.e. to connect them together, to each other). The multilayer flexible printed circuit board is disposed through (e.g. to extend through) a folding area of the electronic device in which the hinge is positioned (or located). The multilayer flexible printed circuit board includes a plurality of pattern (or patterned) layers stacked in a first direction (a height direction) of the multilayer flexible printed circuit board and a bonding layer (or at least one bonding layer) configured to bond a portion between at least two pattern layers of the plurality of pattern layers (or, in other words, bond respective portions of at least one adjacent pair of the plurality of pattern layers). area portion of the multilayer flexible printed circuit board corresponding to the hinge includes first and second flexure areas in which the multilayer flexible printed circuit board is bent and extended (or flexed, e.g. as the electronic device is folded and unfolded, or, in other words, as its configuration is changed between a folded state and an unfolded state), and a non-flexure area NF between the first and second flexure areas. The bonding layer is formed only on (or in, or within) the non-flexure area. Thus, the electronic device may comprises at least one bonding layer that is confined solely, or entirely, to the non-flexure area, and does not extend into the first or second flexure areas, such that in the first and second flexure areas, the adjacent pair of pattern layers, bonded together by the bonding layer in the non-flexure area, are not bonded to each other. In other words, in certain embodiments, the multilayer flexible circuit board comprises a pair of adjacent pattern layers comprising respective portions bonded together in the non-flexure area, other respective portions not bonded together in the first flexure area, and other respective portions not bonded together in the second flexure area, such that the non-bonded portions in the flexure areas can slide or move over, or relative to, one another as the flexure areas flex as the device is folded and unfolded, so helping the flexible circuit board maintain a desired shape and reducing stress.

### [Advantageous Effects of Invention]

An electronic device including a multilayer flexible printed circuit board according to an embodiment of the disclosure disposes a bonding layer only in (or only between) some (i.e. not all) layers of the multilayer flexible printed circuit board in a folding area; thus, the multilayer flexible printed circuit board can easily maintain a determined design shape.

An electronic device including a multilayer flexible printed circuit board according to an embodiment of the disclosure can reduce a path loss of the multilayer flexible printed circuit board compared to the case that the folding area does not include a bonding layer.

An electronic device including a multilayer flexible printed circuit board according to an embodiment of the disclosure disposes a bonding layer in only some layers of the multilayer flexible printed circuit board in a folding area, thereby reducing the stress applied to the multilayer flexible printed circuit board compared to the case of bonding all layers of the multilayer flexible printed circuit board.

### [Brief Description of Drawings]

FIG. 1 is a block diagram illustrating an electronic device in a network environment according to an embodiment.
FIGS. 2A, 2B, 2C, 2D, and 2E are diagrams illustrating an electronic device according to an embodiment of the disclosure.
FIGS. 3A and 3B are diagrams illustrating an electronic device according to an embodiment of the disclosure.
FIG. 4 is a diagram illustrating a multilayer flexible printed circuit board according to an embodiment of the disclosure.
FIG. 5 is a diagram illustrating a multilayer flexible printed circuit board according to an embodiment of the disclosure.
FIG. 6 is a diagram illustrating a multilayer flexible printed circuit board according to an embodiment of the disclosure.
FIG. 7 is a diagram illustrating a multilayer flexible printed circuit board according to an embodiment of the disclosure.
FIG. 8 is a diagram illustrating a multilayer flexible printed circuit board according to an embodiment of the disclosure.
FIGS. 9A and 9B are diagrams illustrating a multilayer flexible printed circuit board according to an embodiment of the disclosure.
FIGS. 10A and 10B are diagrams illustrating a separation distance and effective separation distance between bonding layers according to an embodiment of the disclosure.
FIG. 11 is a diagram illustrating an electronic device according to an embodiment of the disclosure.
FIG. 12 is a diagram illustrating an electronic device including a bonding layer disposed in a first area according to an embodiment of the disclosure.

### [Mode for the Invention]

In the following description, although numerous features may be designated as optional, it is nevertheless acknowledged that all features defined by claim 1 are not to be read as optional.

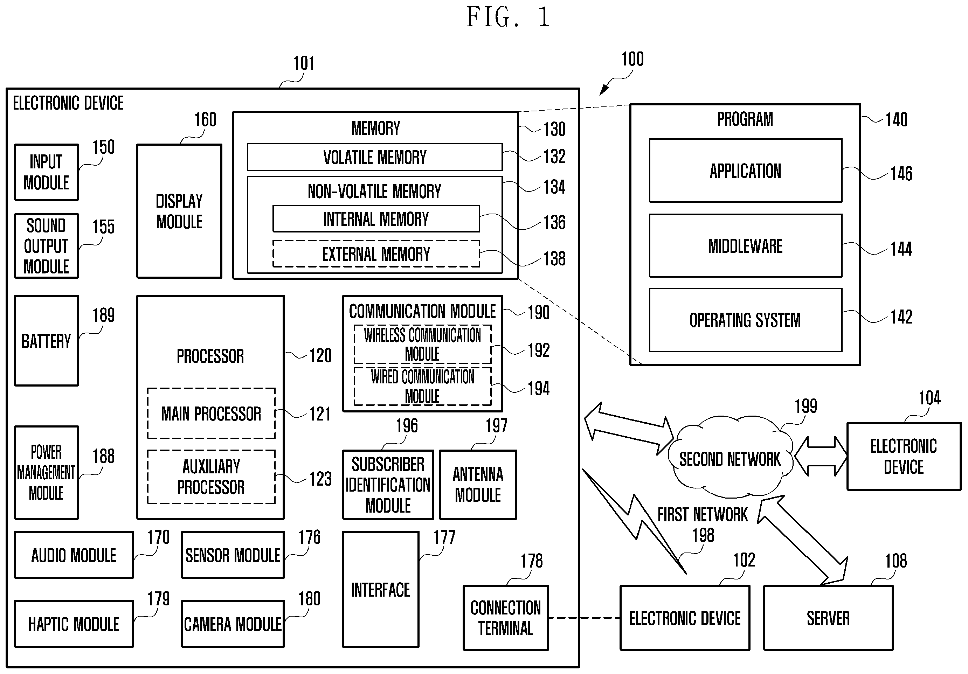

FIG. 1 is a block diagram illustrating an electronic device in a network environment according to an embodiment. Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the millimeter(mm) Wave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

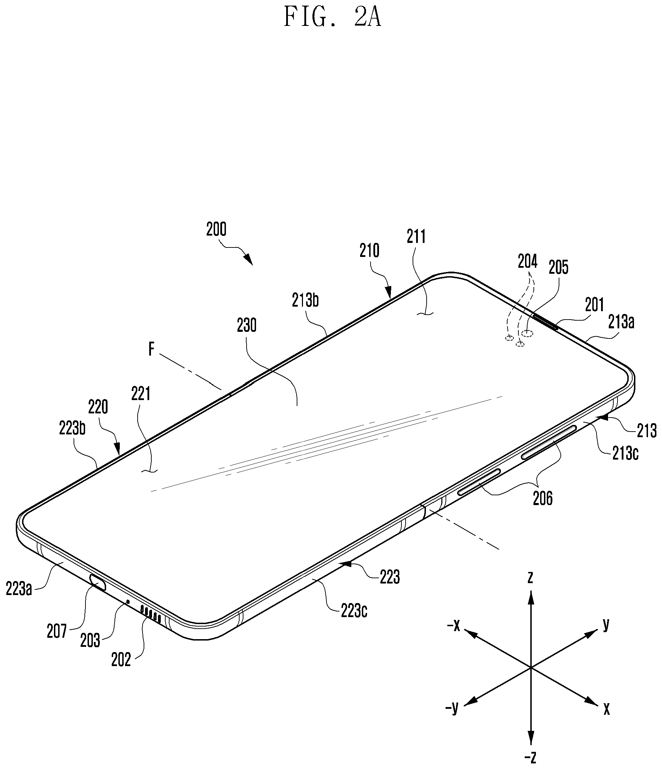

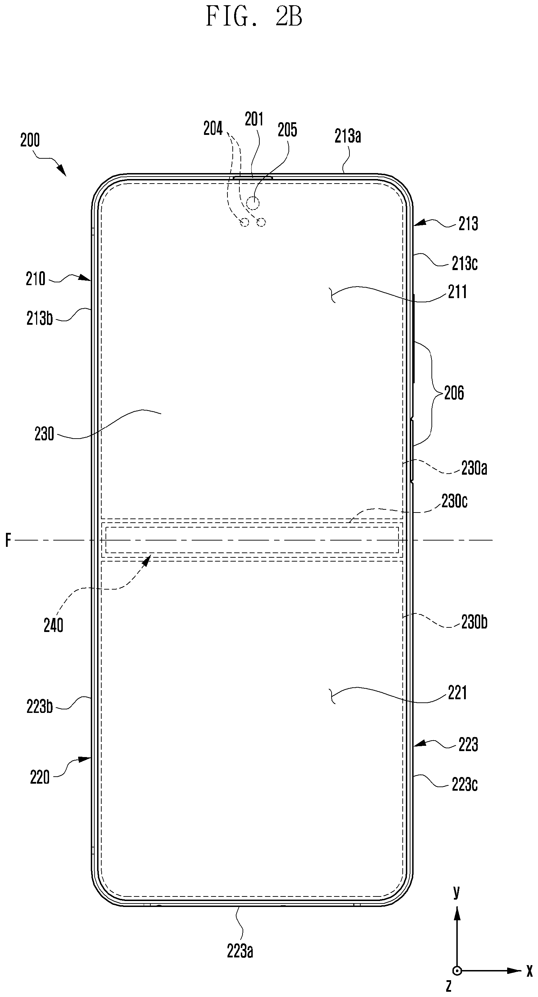

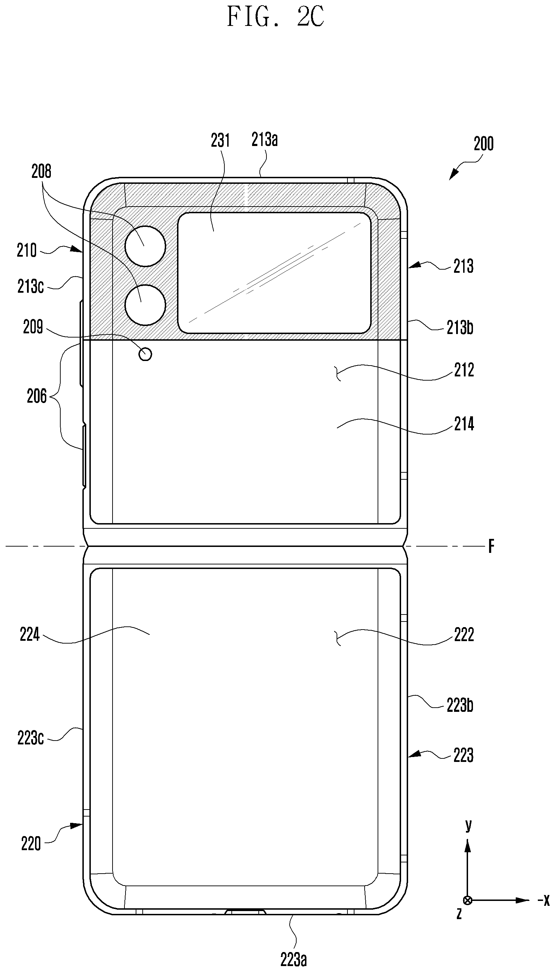

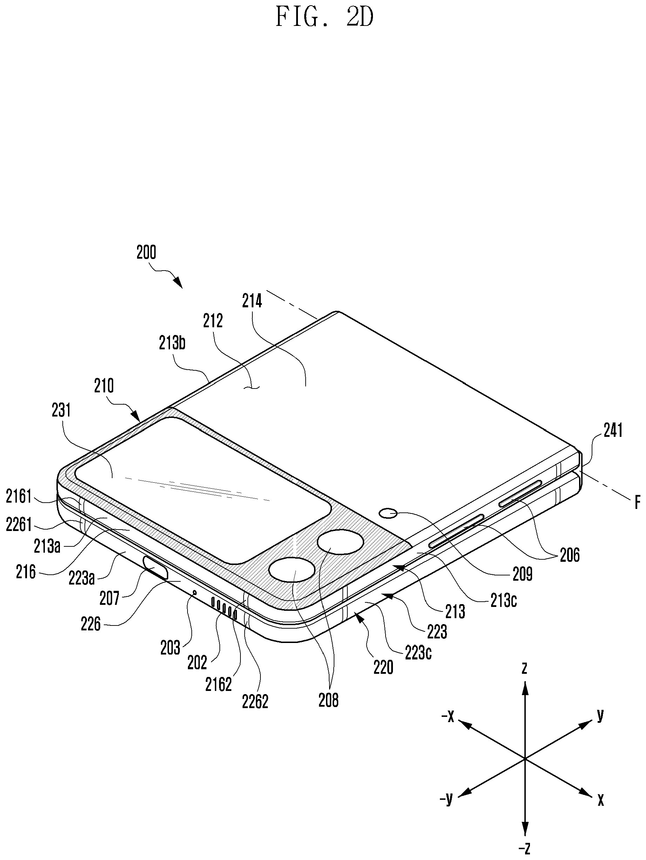

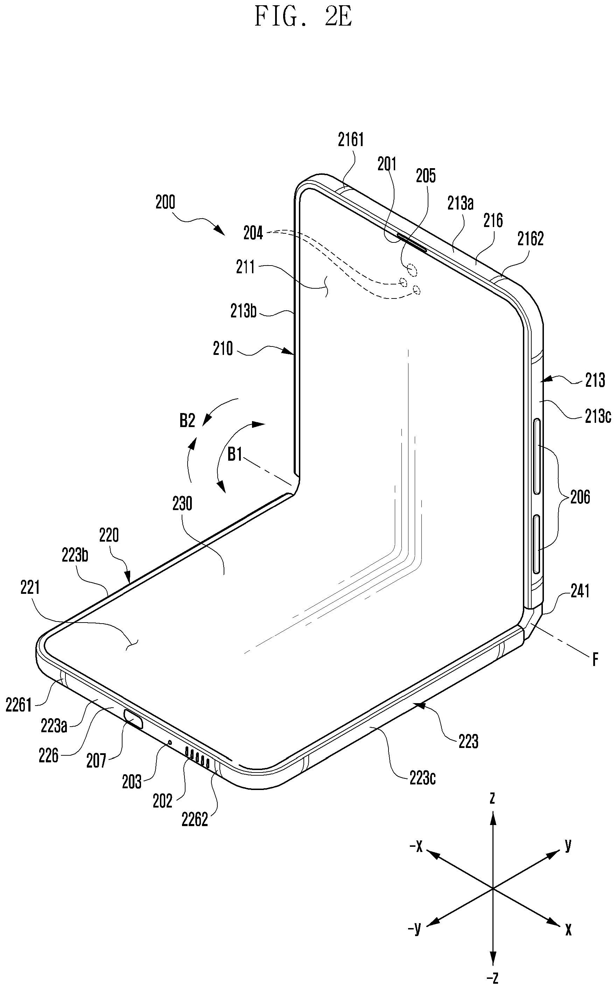

FIGS. 2A, 2B, 2C, 2D, and 2E are diagrams illustrating an electronic device 200 according to an embodiment of the disclosure.

FIG. 2A is a perspective view of an electronic device illustrating an unfolded state (or flat state) of the electronic device according to an embodiment of the disclosure. FIG. 2B is a plan view illustrating a front surface of an electronic device in an unfolded state of the electronic device according to an embodiment of the disclosure. FIG. 2C is a plan view illustrating a rear surface of an electronic device in an unfolded state according to an embodiment of the disclosure. FIG. 2D is a perspective view of an electronic device illustrating a folded state of the electronic device according to an embodiment of the disclosure. FIG. 2E is a perspective view of an electronic device illustrating an intermediate state of the electronic device according to an embodiment of the disclosure.

With reference to FIGS. 2A to 2E, an electronic device 200 may include first and second housings 210 and 220 (e.g., foldable housing structure) combined with each other in a foldable manner based on a hinge device (e.g., hinge device 240 of FIG. 2B). In an embodiment, the hinge device (e.g., hinge device 240 of FIG. 2B) may be disposed in an X-axis direction or in a Y-axis direction. According to an embodiment, the electronic device 200 may include a first display 230 (e.g., flexible display, foldable display, or main display) disposed in an area (e.g., recess) formed by the first and second housings 210 and 220. According to an embodiment, the first housing 210 and the second housing 220 may be disposed on both sides around a folding axis F, and may have a substantially symmetrical shape about the folding axis F. According to an embodiment, an angle or a distance between the first housing 210 and the second housing 220 may differ depending on the state of the electronic device 200. For example, depending on whether the electronic device is in an unfolded state (or flat state), in a folded state, or in an intermediate state, the angle or the distance between the first housing 210 and the second housing 220 may differ.

According to an embodiment, in the unfolded state of the electronic device 200, the first housing 210 may include a first surface 211 directed in a first direction (e.g., front direction) (z-axis direction), and a second surface 212 directed in a second direction (e.g., rear direction) (-z-axis direction) opposite to the first surface 211. According to an embodiment, in the unfolded state of the electronic device 200, the second housing 220 may include a third surface 221 directed in the first direction (z-axis direction), and a fourth surface 222 directed in the second direction (-z-axis direction). According to an embodiment, in the unfolded state of the electronic device 100, the first surface 211 of the first housing 210 and the third surface 221 of the second housing 220 may be directed in substantially the same first direction (z-axis direction). In an embodiment, in the folded state of the electronic device 200, the first surface 211 of the first housing 210 and the third surface 221 of the second housing 220 may face each other. According to an embodiment, in the unfolded state of the electronic device 200, the second surface 212 of the first housing 210 and the fourth surface 222 of the second housing 220 may be directed in substantially the same second direction (-z-axis direction). In an embodiment, in the folded state of the electronic device 200, the second surface 212 of the first housing and the fourth surface 222 of the second housing 220 may be directed in opposite directions. For example, in the folded state of the electronic device 200, the second surface 212 may be directed in the first direction (z-axis direction), and the fourth surface 222 may be directed in the second direction (-z-axis direction). In this case, the first display 230 may not be viewed from outside (in-folding manner). In an embodiment, the electronic device 200 may be folded so that the second surface 212 of the first housing 210 and the fourth surface 222 of the second housing 220 face each other. In this case, the first display 230 may be disposed to be viewed from the outside (out-folding manner).

According to an embodiment, the first housing 210 (e.g., first housing structure) may include a first lateral member 213 forming the appearance of the electronic device 200, and a first rear cover 214 combined with the first lateral member 213, and forming at least a part of the second surface 212 of the electronic device 200. According to an embodiment, the first lateral member 213 may include a first side surface 213a, a second side surface 213b extending from one end of the first side surface 213a, and a third side surface 213c extending from the other end of the first side surface 213a. According to an embodiment, the first lateral member 213 may be formed in a quadrangular (e.g., square or rectangular) shape through the first side surface 213a, the second side surface 213b, and the third side surface 213c.

According to an embodiment, the second housing 220 (e.g., second housing structure) may include a second lateral member 223 forming the appearance of the electronic device 200 at least partly, and a second lateral cover 224 combined with the second lateral member 223, and forming at least a part of the fourth surface 222 of the electronic device 200. According to an embodiment, the second lateral member 223 may include a fourth side surface 223a, a fifth side surface 223b extending from one end of the fourth side surface 223a, and a sixth side surface 223c extending from the other end of the fourth side surface 223a. According to an embodiment, the second lateral member 223 may be formed in a quadrangular shape through the fourth side surface 223a, the fifth side surface 223b, and the sixth side surface 223c.

According to an embodiment, the first and second housings 210 and 220 are not limited to the illustrated shapes and combinations, but may be implemented by combinations and/or compositions of other shapes or components. In an embodiment, the first lateral member 213 may be integrally formed with the first rear cover 214, and the second lateral member 223 may be integrally formed with the second rear cover 224.

According to an embodiment, in the unfolded state of the electronic device 200, the second side surface 213b of the first lateral member 213 and the fifth side surface 223b of the second lateral member 223 may be connected to each other without a gap. According to an embodiment, in the unfolded state of the electronic device 200, the third side surface 213c of the first lateral member 213 and the sixth side surface 223c of the second lateral member 223 may be connected to each other without a gap. According to an embodiment, in the unfolded state of the electronic device 200, the sum of the lengths of the second side surface 213b and the fifth side surface 223b may be configured to be longer than the length of the first side surface 213a and/or the fourth side surface 223a. According to an embodiment, in the unfolded state of the electronic device 200, the sum of the lengths of the third side surface 213c and the sixth side surface 223c may be configured to be longer than the length of the first side surface 213a and/or the fourth side surface 223a.

With reference to FIGS. 2D and 2E, the first lateral member 213 and/or the second lateral member 223 may be formed of metal, or may further include polymer that is injected into metal. According to an embodiment, the first lateral member 213 and/or the second lateral member 223 may include at least one conductive part 216 and/or 226 electrically segmented through at least one segment part 2161, 2162 and/or 2261, 2262 formed of polymer. In this case, the at least one conductive part 216 and/or 226 may be electrically connected to a wireless communication circuit included in the electronic device 200, and thus may be used as at least a part of an antenna that operates in at least one designated band (e.g., legacy band).

According to an embodiment, the first rear cover 214 and/or the second rear cover 224 may be formed of, for example, at least one of coated or colored glass, ceramic, polymer, or metal (e.g., aluminum, stainless steel (STS), or magnesium) or a combination of at least two thereof.

According to an embodiment, the first display 230 may be disposed to extend from the first surface 211 of the first housing 210 to at least a part of the third surface 221 of the second housing 220 across the hinge device (e.g., hinge device 240 of FIG. 2B). In an embodiment, the first display 230 may include a first area 230a substantially corresponding to the first surface 211, a second area 230b corresponding to the second surface 221, and a third area 230c (e.g., flexible area or folding area) connecting the first area 230a and the second area 230b to each other. According to an embodiment, the third area 230c may be a part of the first area 220a and/or the second area 230b, and may be disposed at a location corresponding to the hinge device (e.g., hinge device 240 of FIG. 2B). According to an embodiment, the electronic device 200 may include a hinge housing 241 (e.g., hinge cover) supporting the hinge device (e.g., hinge device 240 of FIG. 2B). In an embodiment, the hinge housing 241 may be disposed to be exposed to outside when the electronic device 200 is in a folded state, and not to be viewed from the outside as being drawn into an inner space of the first housing 210 and an inner space of the second housing 220 when the electronic device 200 is in an unfolded state.

According to an embodiment, the electronic device 200 may include a second display 231 (e.g., sub-display) disposed separately from the first display 230. According to an embodiment, the second display 231 may be disposed to be exposed at least partly on the second surface 212 of the first housing 210. In an embodiment, when the electronic device 200 is in the folded state, the second display 231 may display at least a part of state information of the electronic device 200 in replacement of at least a part of a display function of the first display 230. According to an embodiment, the second display 231 may be disposed to be viewed from the outside through at least a partial area of the first rear cover 214. In an embodiment, the second display 231 may be disposed on the fourth surface 222 of the second housing 220. In this case, the second display 231 may be disposed to be viewed from the outside through at least a partial area of the second rear cover 224.

According to an embodiment, the electronic device 200 may include at least one of an input device 203 (e.g., microphone), sound output devices 201 and 202, a sensor module 204, camera devices 205 and 208, a key input device 206, or a connector port 207. In an illustrated embodiment, although the input device 203 (e.g., microphone), the sound output devices 201 and 202, the sensor module 204, the camera devices 205 and 208, the key input device 206, or the connector port 207 are illustrated as hole or circular shaped elements formed on the first housing 210 or the second housing 220, they are exemplarily illustrated for explanation, but are not limited thereto. According to an embodiment, the input device 203 may include at least one microphone 203 disposed on the second housing 220. In an embodiment, the input device 203 may include a plurality of microphones 203 disposed to sense the sound direction. In an embodiment, the plurality of microphone 203 may be disposed at proper locations on the first housing 210 and/or the second housing 220. According to an embodiment, the sound output devices 201 and 202 may include at least one speaker 201 and 202. According to an embodiment, the at least one speaker 201 and 202 may include a receiver 201 for call disposed on the first housing 210, and the speaker 202 disposed on the second housing 220. In an embodiment, the input device 203, the sound output devices 201 and 202, and the connector port 207 may be disposed in a space provided in the first housing 210 and/or the second housing 220 of the electronic device 200, and may be exposed to an external environment through at least one hole formed on the first housing 210 and/or the second housing 220. According to an embodiment, the at least one connector port 207 may be used to transmit and receive power and/or data to and from an external electronic device. In an embodiment, the at least one connector port (e.g., ear jack hole) may accommodate a connector (e.g., ear jack) for transmitting and receiving an audio signal to and from the external electronic device. In an embodiment, the hole formed on the first housing 210 and/or the second housing 220 may be commonly used for the input device 203 and the sound output devices 201 and 202. In an embodiment, the sound output devices 201 and 202 may include a speaker (e.g., piezo-electric speaker) that is not exposed through the hole formed on the first housing 210 and/or the second housing 220.

According to an embodiment, the sensor module 204 may generate an electrical signal or a data value corresponding to an internal operation state of the electronic device 200 or an external environment state. According to an embodiment, the sensor module 204 may detect the external environment through the first surface 211 of the first housing 210. In an embodiment, the electronic device 200 may further include at least one sensor module disposed to detect the external environment through the second surface 212 of the first housing 210. According to an embodiment, the sensor module 204 (e.g., illumination sensor) may be disposed to detect the external environment through the first display 230 under the first display 230. According to an embodiment, the sensor module 204 may include at least one of a gesture sensor, a gyro sensor, a barometric pressure sensor, a magnetic sensor, an acceleration sensor, a grip sensor, a color sensor, an infrared (IR) sensor, a biosensor, a temperature sensor, a humidity sensor, an illumination sensor, a proximity sensor, a biosensor, an ultrasonic sensor, or an illumination sensor 204.

According to an embodiment, the camera devices 205 and 208 may include the first camera device 205 (e.g., front camera device) disposed on the first surface 211 of the first housing 210, and the second camera device 208 disposed on the second surface 212 of the first housing 210. In an embodiment, the electronic device 200 may further include a flash 209 disposed near the second camera device 208. According to an embodiment, the camera devices 205 and 208 may include at least one lens, an image sensor, and/or an image signal processor. According to an embodiment, the camera devices 205 and 208 may be disposed so that two or more lenses (e.g., wide angle lens, ultra wide angle lens, or telephoto lens) and two or more image sensors are located on one surface (e.g., first surface 211, second surface 212, third surface 221, or fourth surface 222) of the electronic device 200. In an embodiment, the camera devices 205 and 208 may include lenses for time of flight (TOF) and/or image sensors.

According to an embodiment, the key input device 206 (e.g., key buttons) may be disposed on the third side surface 213c of the first lateral member 213 of the first housing 210. In an embodiment, the key input device 206 may be disposed on at least one side surface of other side surfaces 213a and 213b of the first housing 210 and/or side surfaces 223a, 223b, and 223c of the second housing 220. In an embodiment, the electronic device 200 may not include some or all of the key input devices 206, and the non-included key input device 206 may be implemented in another form, such as a soft key, on the first display 230. In an embodiment, the key input device 206 may be implemented by using the pressure sensor included in the first display 230.

According to an embodiment, one of the camera devices 205 and 208 (e.g., first camera device 205) or the sensor module 204 may be disposed to be exposed through the first display 230. According to an embodiment, the first camera device 205 or the sensor module 204 may be optically exposed to the outside through an opening (e.g., through-hole) formed at least partly on the first display 230 in the inner space of the electronic device 200. According to an embodiment, at least a part of the sensor module 204 may be disposed not to be visually exposed through the first display 230 in the inner space of the electronic device 200. With reference to FIG. 2E, the electronic device 200 may operate to maintain at least one designated folding angle in an intermediate state through the hinge device (e.g., hinge device 240 of FIG. 2B). In this case, the electronic device 200 may control the first display 230 so that different kinds of content are displayed on the display area corresponding to the first surface 211 and the display area corresponding to the third surface 221. According to an embodiment, the electronic device 200 may operate in substantially the unfolded state (e.g., unfolded state of FIG. 2A) and/or in substantially the folded state (e.g., folded state of FIG. 2D) based on a specific folding angle (e.g., angle between the first housing 210 and the second housing 220 when the electronic device 200 is in the intermediate state) through the hinge device (e.g., hinge device 240 of FIG. 2B). In an embodiment, if a pressing force is provided in an unfolding direction (direction B1) in a state where the electronic device 200 is unfolded at the specific folding angle through the hinge device (e.g., hinge device 240 of FIG. 2B), the electronic device 200 may operate to be transitioned to the unfolded state (e.g., unfolded state of FIG. 2A). In an embodiment, if the pressing force is provided in a folding direction (direction B2) in a state where the electronic device 200 is unfolded at the specific folding angle through the hinge device (e.g., hinge device 240 of FIG. 2B), the electronic device 200 may operate to be transitioned to the folded state (e.g., folded state of FIG. 2D). In an embodiment, the electronic device 200 may operate to maintain the unfolded state (not illustrated) at various angles through the hinge device (e.g., hinge device 240 of FIG. 2B) (free-stop function).

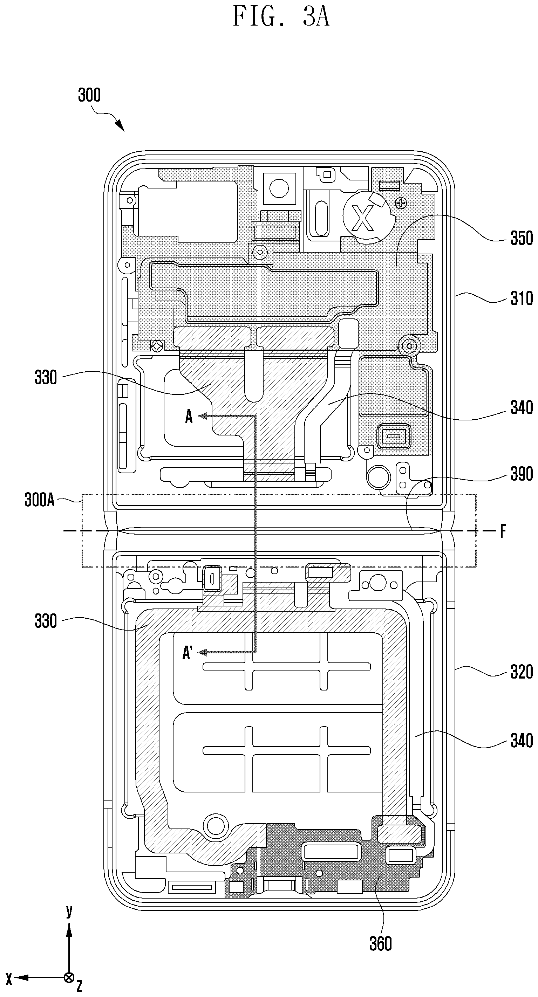

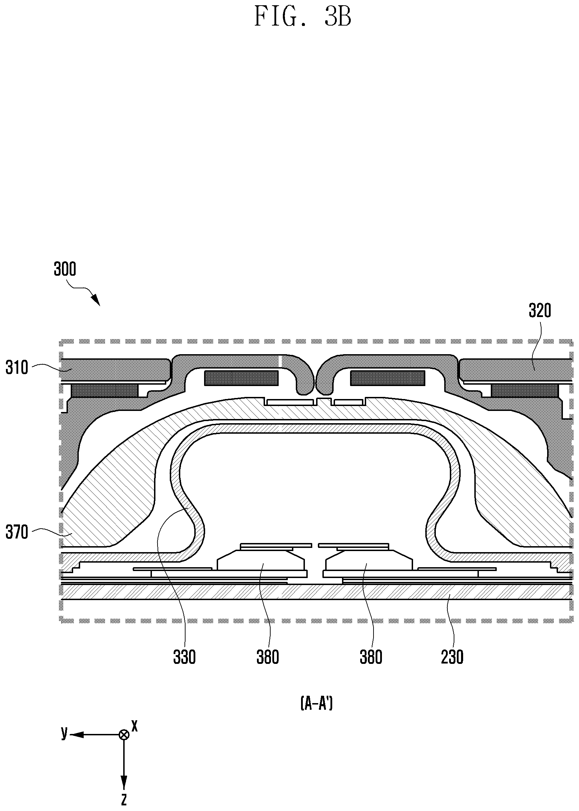

FIGS. 3A and 3B are diagrams illustrating an electronic device 300 according to an embodiment of the disclosure.

FIG. 3A is a diagram illustrating an electronic device 300 according to an embodiment of the disclosure. FIG. 3B is a cross-sectional view illustrating an electronic device 300 taken along line A-A' illustrated in FIG. 3A according to an embodiment of the disclosure.

In describing the electronic device 300 according to an embodiment of the disclosure, a length direction of the electronic device 300 may mean the y-axis direction, and a width direction thereof may mean the x-axis direction. A height direction of the electronic device 300 may mean the z-axis direction.

With reference to FIGS. 3A and 3B, the electronic device 300 according to an embodiment of the disclosure may include a first housing 310, a second housing 320, a first flexible printed circuit board 330, a second flexible circuit board 340, a first printed circuit board 350, a second printed circuit board 360, a hinge housing 370, a support member 380, and/or a display 230.

The electronic device 300 according to an embodiment illustrated in FIG. 3A may mean the electronic device 200 of FIG. 2A or may include at least a portion of the electronic device 200 of FIG. 2A.

The electronic device 300 according to an embodiment of the disclosure may be a foldable type device. The first housing 310 and the second housing 320 may be foldably coupled to each other about a folding axis F.

In an embodiment, the electronic device 300 may include a folding area 300A (which may also be described as a folding region or folding portion) positioned between the first housing 310 and the second housing 320. In the folding area 300A, a hinge 390 for enabling the first housing 310 and the second housing 320 to rotate may be positioned. The first housing 310 and the second housing 320 may be rotatably (or foldably) connected to each other through the hinge 390.

In an embodiment, the first printed circuit board 350 may be disposed in the first housing 310. The second printed circuit board 360 may be disposed in the second housing 320.

In an embodiment, in the first printed circuit board 350 and/or the second printed circuit board 360, the processor 120 (see FIG. 1) and/or the memory 130 (see FIG. 1) may be disposed. The processor 120 (see FIG. 1) may include a main processor 121 (see FIG. 1) (e.g., central processor or processor) or an auxiliary processor 123 (see FIG. 1) (e.g., graphics processing device, neural processer (NPU), image signal processor, sensor hub processor, or communication processor) capable of operating independently or together with the main processor. The memory 130 (see FIG. 1) may include a volatile memory 132 (see FIG. 1) or a non-volatile memory 134 (see FIG. 1).

In an embodiment, the first flexible printed circuit board 330 may be disposed in the first housing 310 and the second housing 320. The first flexible printed circuit board 330 may extend from the first housing 310 toward the second housing 320 through the folding area 300A.

In an embodiment, one end of the first flexible printed circuit board 330 may be connected to the first printed circuit board 350, and the other end of the first flexible printed circuit board 330 may be connected to the second printed circuit board 360. The first flexible printed circuit board 330 may electrically connect the first printed circuit board 350 and the second printed circuit board 360.

In an embodiment, the second flexible printed circuit board 340 may be disposed in the first housing 310 and the second housing 320. The second flexible printed circuit board 340 may extend from the first housing 310 toward the second housing 320 through the folding area 300A.

In an embodiment, one end of the second flexible printed circuit board 340 may be connected to the first printed circuit board 350, and the other end of the second flexible printed circuit board 340 may be connected to the second printed circuit board 360. The second flexible printed circuit board 340 may electrically connect the first printed circuit board 350 and the second printed circuit board 360.

FIG. 3B illustrates a folding area 300A (see FIG. 3A) of the electronic device 300 according to an embodiment.

With reference to FIG. 3B, in the folding area 300A (see FIG. 3A) of the electronic device 300, at least a portion of the first housing 310, the second housing 320, the hinge housing 370, the first flexible printed circuit board 330, the support member 380, and the display 230 may be disposed.

In an embodiment, the hinge housing 370 may mean the hinge housing 241 of FIG. 2E or may include at least a portion of the hinge housing 241 of FIG. 2E.

In an embodiment, the display 230 may mean the first display 230 of FIG. 2A or may include at least a portion of the first display 230 of FIG. 2A.

In an embodiment, the support member 380 may perform a function of supporting the display 230 disposed in the electronic device 300. For example, the support member 380 may support the display 230 positioned in a positive z-axis direction thereof.

With reference to FIG. 3B, in the folding area 300A, the first flexible printed circuit board 330 may be disposed between the support member 380 and the hinge housing 370.

In an embodiment, the hinge housing 370 may be disposed to enclose an outer edge of the first flexible printed circuit board 330 in the folding area 300A.

With reference to FIG. 3B, in the folding area 300A of the electronic device 300, the first flexible printed circuit board 330 may be bent and extended at least in part. For example, the first flexible printed circuit board 330 may be bent at least in part while being extended in a direction substantially parallel to a length direction (e.g., y-axis direction) of the electronic device 300 and be extended in a height direction (e.g., z-axis direction) of the electronic device 300.

With reference to FIG. 3B, the first flexible printed circuit board 330 may be extended in a direction substantially parallel to a length direction (e.g., y-axis direction) at a center point (e.g., a point at which the first housing 310 and the second housing 320 face in the folding area 300A) of the folding area 300A in the length direction (e.g., the y-axis direction).

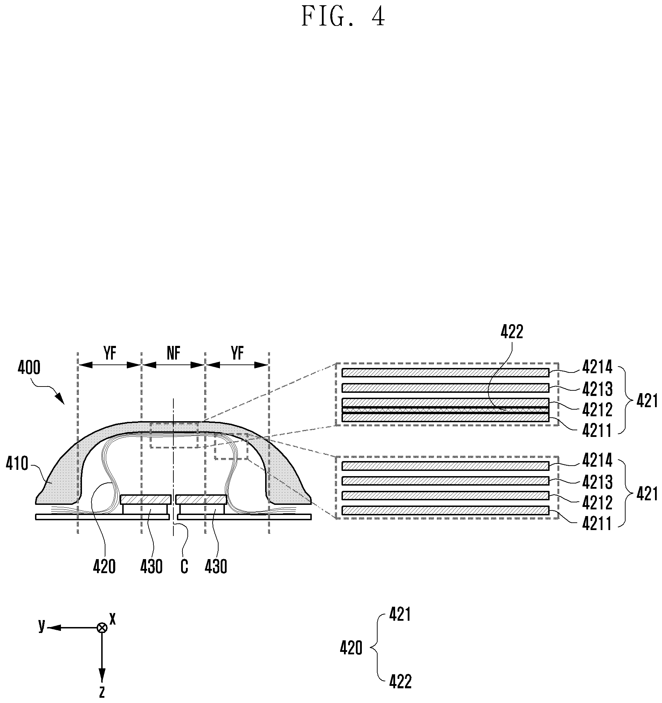

FIG. 4 is a diagram illustrating a multilayer flexible printed circuit board 420 according to an embodiment of the disclosure.

An electronic device 400 according to an embodiment of the disclosure may mean the electronic device 200 of FIG. 2A or the electronic device 300 of FIG. 3A or may be a device including at least a portion of the electronic device 200 of FIG. 2A and the electronic device 300 of FIG. 3A. For example, the electronic device 400 may be a foldable type device such as the electronic device 200 illustrated in FIG. 2A.

FIG. 4 is a diagram illustrating a portion of an electronic device 400 according to an embodiment. For example, FIG. 4 may be a diagram illustrating a cross section of the folding area 300A (see FIGS. 3A and 3B) of the electronic device 400. FIG. 4 is a diagram illustrating the multilayer flexible printed circuit board 420 disposed in the folding area 300A (see FIG. 3A) in an unfolded state of the electronic device 400.

In an embodiment, the electronic device 400 may include a hinge housing 410, a multilayer flexible printed circuit board 420, and/or a support member 430. A shape and function of the hinge housing 410 and the support member 430 may be substantially the same as those of the hinge housing 370 and the support member 380, respectively of FIG. 3B. The multilayer flexible printed circuit board 420 may mean the first flexible printed circuit board 330 or the second flexible printed circuit board 340 of FIG. 3A or may be a board having substantially the same function as that of the first flexible printed circuit board 330 or the second flexible printed circuit board 340 of FIG. 3A.

In an embodiment, the multilayer flexible printed circuit board 420 may include a pattern (or patterned) layer 421 and/or a bonding layer 422.

In an embodiment, the pattern layer 421 may be a layer through which electrical signals are transmitted in the multilayer flexible printed circuit board 420. The pattern layer may alternatively be described as a patterned layer, a conductive layer, a signal layer, a tracked layer, or a connecting layer.

In an embodiment, the pattern layer 421 may include an insulator, a conductive pattern (e.g., copper foil), and/or an adhesive. For example, the pattern layer 421 may be an insulator in which a conductive pattern (e.g., copper foil) is formed at one surface or the other surface thereof. The pattern layer 421 may include an adhesive for adhesion to other layers.

In an embodiment, the pattern layer 421 may be composed of a plurality of layers. For example, the pattern layer 421 may be composed of a plurality of layers and include a layer including an insulator and a layer including a conductive pattern.

In an embodiment, the bonding layer 422 may perform a function of bonding the two pattern layers 421 to each other. The bonding layer 422 may include an adhesive including an epoxy-based resin, but a material of the bonding layer 422 may not be limited thereto.

In an embodiment, the bonding layer 422 may include prepreg. For example, the bonding layer 422 may have a form of a bonding sheet including prepreg.

In an embodiment, the multilayer flexible printed circuit board 420 may include a plurality of pattern layers 421. The pattern layer 421 may include a first pattern layer 4211, a second pattern layer 4212, a third pattern layer 4213, and/or a fourth pattern layer 4214. The bonding layer 422 may be arranged to bond together respective portions of an adjacent pair of the plurality of pattern layers, those respective portions for example being confined to the non-flexure area NF.

With reference to FIG. 4, in the multilayer flexible printed circuit board 420, the pattern layer 421 may be stacked in order of the first pattern layer 4211, the second pattern layer 4212, the third pattern layer 4213, and the fourth pattern layer 4214. For example, the second pattern layer 4212 may be stacked in one direction of the first pattern layer 4211, and the third pattern layer 4213 may be stacked in one direction of the second pattern layer 4212. The fourth pattern layer 4214 may be stacked in one direction of the third pattern layer 4213.

In an embodiment, each of the pattern layers 4211, 4212, 4213, and 4214 included in the multilayer flexible printed circuit board 420 may be constituted to be insulated from each other.

In an embodiment, the first pattern layer 4211 may be a layer positioned furthest from the hinge housing 410 in the multilayer flexible printed circuit board 420. The fourth pattern layer 4214 may be a layer positioned closest to the hinge housing 410 in the multilayer flexible printed circuit board 420.

In an embodiment, the first pattern layer 4211 may be a layer positioned closest to the display (e.g., the display 230 of FIG. 3B) in the multilayer flexible printed circuit board 420. The fourth pattern layer 4214 may be a layer positioned furthest from the display (e.g., the display 230 of FIG. 3B) in the multilayer flexible printed circuit board 420.

In an embodiment, the multilayer flexible printed circuit board 420 may include a non-flexure area NF and/or a flexure area YF. The flexure area YF may be an area in which the multilayer flexible printed circuit board 420 is bent and extended at least in part. The non-flexure area NF may be an area in which the multilayer flexible printed circuit board 420 is bent and extended smaller than the flexure area YF. For example, the non-flexure area NF may be flat or may have a curvature smaller than that of the flexure area YF. The multilayer flexible printed circuit board 420 may be extended in one direction without being bent in the non-flexure area NF, or may be bent and extended smaller in the non-flexure area NF than in the flexure area YF.

In an embodiment, at least a portion of the non-flexure area NF may be positioned at a center C of the folding area.

In an embodiment, the flexure area YF may be formed at a position symmetrical about the non-flexure area NF. The flexure area YF is positioned at one end and the other end of the non-flexure area NF.

In an embodiment, the bonding layer 422 may be disposed in the non-flexure area NF of the multilayer flexible printed circuit board 420. For example, the bonding layer 422 may be disposed only in the non-flexure area NF but may not be disposed in the flexure area YF.

In an embodiment, in the non-flexure area NF of the multilayer flexible printed circuit board 420, the bonding layer 422 may be disposed between the first pattern layer 4211 and the second pattern layer 4212, and may bond together a portion of the first pattern layer and a portion of the second pattern layer. With reference to FIG. 4, the first pattern layer 4211 in which the bonding layer 422 is disposed may be the pattern layer 421 positioned furthest from the hinge housing 410.

In FIG. 4, although it is illustrated that the bonding layer 422 is positioned between the pattern layers 421 positioned furthest from the hinge housing 410, a position of the bonding layer 422 may not be limited thereto. For example, the bonding layer 422 may be disposed between the second pattern layer 4212 and the third pattern layer 4213 in the non-flexure area NF.

In an embodiment, the bonding layer 422 may have a predetermined thickness between the first pattern layer 4211 and the second pattern layer 4212 and be extended in a length direction of the multilayer flexible printed circuit board 420. Because the bonding layer 422 has a predetermined thickness and is extended, the first pattern layer 4211 and the second pattern layer 4212 may be disposed at a predetermined distance from each other.

In an embodiment, in the non-flexure area NF of the multilayer flexible printed circuit board 420, the bonding layer 422 may not be disposed between the second pattern layer 4212 and the third pattern layer 4213 and between the third pattern layer 4213 and the fourth pattern layer 4214.

As the bonding layer 422 is positioned at a layer (e.g., a layer farther from the hinge housing 410) closer to the display (e.g., the display 230 of FIG. 3B) in the multilayer flexible printed circuit board 420, the multilayer flexible printed circuit board 420 may easily maintain a determined design shape. In the multilayer flexible printed circuit board 420 according to an embodiment, because the bonding layer 422 is disposed between the first pattern layer 4211 and the second pattern layer 4212, when the multilayer flexible printed circuit board 420 is bent, the tension caused by the bonding layer 422 is transmitted to the third pattern layer 4213 and the fourth pattern layer 4214; thus, the multilayer flexible printed circuit board 420 may easily maintain a determined design shape.

As the number of pattern layers 421 bonded to each other becomes smaller in the multilayer flexible printed circuit board 420, the multilayer flexible printed circuit board 420 may easily maintain a determined design shape. For example, in the case that three or more pattern layers 421 are bonded to each other, a reaction force generated in the pattern layers 421 increases; thus, it may be difficult for the multilayer flexible printed circuit board 420 to maintain a determined design shape. Because the multilayer flexible printed circuit board 420 according to an embodiment enables only two pattern layers 421 to be bonded to each other, the multilayer flexible printed circuit board 420 may easily maintain a determined design shape. In other words, in certain embodiments, just one pair of adjacent pattern layers are bonded together, with the remaining pairs of adjacent pattern layers not being bonded together.

As the number of pattern layers 421 bonded to each other becomes smaller in the multilayer flexible printed circuit board 420, the stress applied to the multilayer flexible printed circuit board 420 may reduce. In the case that three or more pattern layers 421 are bonded to each other, a reaction force generated in the pattern layer 421 increases; thus, the stress applied to the multilayer flexible printed circuit board 420 increases, thereby reducing the lifespan of the multilayer flexible printed circuit board 420. In the multilayer flexible printed circuit board 420 according to an embodiment, because only two pattern layers 421 are bonded to each other, the stress applied to the multilayer flexible printed circuit board 420 is reduced, thereby increasing the lifespan of the multilayer flexible printed circuit board 420.

As the bonding layer 422 is positioned adjacent to the flexure area YF in the multilayer flexible printed circuit board 420, the stress applied to a bending portion of the multilayer flexible printed circuit board 420 may increase. In the multilayer flexible printed circuit board 420 according to an embodiment, by forming the bonding layer 422 only in the non-flexure area NF, the stress applied to the bending portion of the multilayer flexible printed circuit board 420 may reduce.

In the case that the multilayer flexible printed circuit board 420 includes the bonding layer 422, a path loss of the multilayer flexible printed circuit board 420 may reduce. For example, a gap between the pattern layers 421 in which the bonding layer 422 is disposed is maintained by the thickness of the bonding layer 422 to form a transmission line; thus, a path loss of the multilayer flexible printed circuit board 420 may reduce. A transmission line having the pattern layer 421 in which the bonding layer 422 is disposed may be a strip line or a micro strip line. Because the multilayer flexible printed circuit board 420 according to an embodiment includes the bonding layer 422 in at least a portion thereof, a path loss may be reduced compared to the case of not including the bonding layer 422.

In FIG. 4, although it is illustrated that the bonding layer 422 is disposed only between two pattern layers 421, the multilayer flexible printed circuit board 420 according to an embodiment may include a plurality of bonding layers 422 in the non-flexure area NF, and the plurality of bonding layers 422 may be positioned between different pattern layers 421. Even in the case that the multilayer flexible printed circuit board 420 includes a plurality of bonding layers 422, the bonding layer 422 may not be formed between at least two pattern layers 421. The multilayer flexible printed circuit board 420 according to an embodiment may not have at least one bonding layer 422 formed in the pattern layer 421 in the non-flexure area NF. In other words, in certain embodiments the multilayer flexible printed circuit board comprises at least one adjacent pair of pattern layers that are not bonded together in the flexure areas.

In an embodiment, flexibility of the non-flexure area NF in which the bonding layer 422 is formed may be lower than that of the flexure area YF. In an embodiment, flexibility may mean the degree to which the multilayer flexible printed circuit board 420 is easy to bend. The flexure area YF of the multilayer flexible printed circuit board 420 may be easily bent compared to the non-flexure area NF in which the bonding layer 422 is formed.

In an embodiment, the multilayer flexible printed circuit board 420 may include a bonding layer 422 formed at least in part between the pattern layers 421 in areas other than the folding area 300A (see FIG. 3A). For example, FIG. 4 illustrates the multilayer flexible printed circuit board 420 in the folding area 300A of the electronic device 400, but the multilayer flexible printed circuit board 420 may include a bonding layer 422 in areas other than the folding area not illustrated in FIG. 4. In areas other than the folding area, the multilayer flexible printed circuit board 420 may include all of the bonding layers 422 between each pattern layer 421 or include the bonding layer 422 only between some pattern layers 421 among the plurality of pattern layers 421.

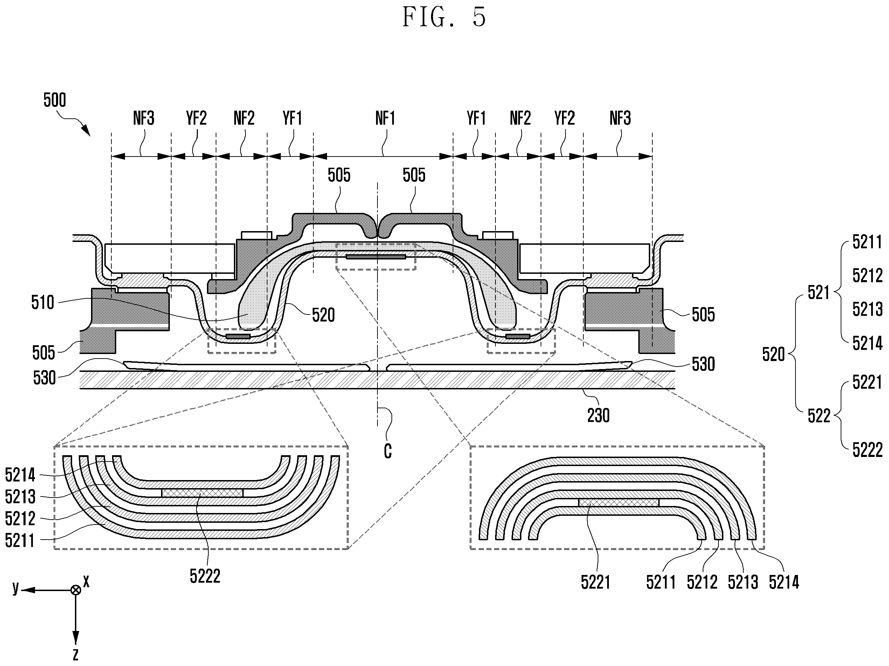

FIG. 5 is a diagram illustrating a multilayer flexible printed circuit board 520 according to an embodiment of the disclosure.

An electronic device 500 according to an embodiment may mean the electronic device 200 of FIG. 2A or the electronic device 300 of FIG. 3A or may be a device including at least a portion of the electronic device 200 of FIG. 2A and the electronic device 300 of FIG. 3A. For example, the electronic device 500 may be a foldable type device such as the electronic device 200 illustrated in FIG. 2A.

FIG. 5 is a diagram illustrating a portion of an electronic device 500 according to an embodiment. For example, FIG. 5 may be a diagram illustrating a cross section of the folding area 300A (see FIGS. 3A and 3B) of the electronic device 500. FIG. 5 is a diagram illustrating the multilayer flexible printed circuit board 520 disposed in the folding area 300A (see FIG. 3A) in an unfolded state of the electronic device 500.

In an embodiment, the electronic device 500 may include a housing 505, a hinge housing 510, a multilayer flexible printed circuit board 520, a support member 530, and/or a display 230. Functions of the housing 505, the hinge housing 510, the multilayer flexible printed circuit board 520, and the support member 530 may be substantially the same as those of the housings 310 and 320, the hinge housing 370, the first flexible printed circuit board 330, the support member 380, and the display 230 of FIG. 3B.

In an embodiment, the multilayer flexible printed circuit board 520 may be disposed between the hinge housing 510 and the support member 530.

In an embodiment, the multilayer flexible printed circuit board 520 may include a pattern layer 521 and/or a bonding layer 522.

A function and material of the pattern layer 521 and the bonding layer 522 according to an embodiment may be substantially the same as those of the pattern layer 421 and the bonding layer 422 of FIG. 4. A description of the function and material of the pattern layer 521 and the bonding layer 522 may be omitted.

In an embodiment, the multilayer flexible printed circuit board 520 may include a plurality of pattern layers 521. The pattern layer 521 may include a first pattern layer 5211, a second pattern layer 5212, a third pattern layer 5213, and/or a fourth pattern layer 5214.

With reference to FIG. 5, in the multilayer flexible printed circuit board 520, the pattern layer 521 may be stacked in order of the first pattern layer 5211, the second pattern layer 5212, the third pattern layer 5213, and the fourth pattern layer 5214. For example, the second pattern layer 5212 may be stacked in one direction of the first pattern layer 5211, and the third pattern layer 5213 may be stacked in one direction of the second pattern layer 5212. The fourth pattern layer 5214 may be stacked in one direction of the third pattern layer 5213.

In an embodiment, the first pattern layer 5211 may be a layer positioned furthest from the hinge housing 510 in the multilayer flexible printed circuit board 520. The fourth pattern layer 5214 may be a layer positioned closest to the hinge housing 510 in the multilayer flexible printed circuit board 520.

In an embodiment, the first pattern layer 5211 may be a layer positioned closest to the display 230 in the multilayer flexible printed circuit board 520. The fourth pattern layer 5214 may be a layer positioned furthest from the display 230 in the multilayer flexible printed circuit board 520.

In an embodiment, the bonding layer 522 may include a first bonding layer 5221 and/or a second bonding layer 5222.

In an embodiment, the multilayer flexible printed circuit board 520 may include a first non-flexure area NF1, a second non-flexure area NF2, a third non-flexure area NF3, a first flexure area YF1, and/or a second flexure area YF2.

In an embodiment, the first non-flexure area NF1, the second non-flexure area NF2, and the third non-flexure area NF3 may be areas in which the multilayer flexible printed circuit board 520 is not bent but is extended in one direction. The first flexure area YF1 and the second flexure area YF2 may be areas in which the multilayer flexible printed circuit board 520 is bent and extended at least in part.

In an embodiment, the second non-flexure area NF2, the third non-flexure area NF3, the first flexure area YF1, and the second flexure area YF2 each two may be formed at positions symmetrical about the first non-flexure area NF1. The first flexure area YF1 is positioned at one end and the other end of the first non-flexure area NF1. The second non-flexure area NF2 may be positioned between the first flexure areas YF1 in one direction and the other direction of the first non-flexure area NF1. The third non-flexure area NF3 may be positioned between the first flexure area YF1, the second non-flexure area NF2, and the second flexure area YF2 in one direction and the other direction of the first non-flexure area NF1.

In an embodiment, at least a portion of the first non-flexure area NF1 may be positioned at a center C of the folding area. The second non-flexure area NF2 may be positioned symmetrically about the first non-flexure area NF1.

In an embodiment, the first flexure area YF1 may be positioned between the first non-flexure area NF1 and the second non-flexure area NF2. For example, the multilayer flexible printed circuit board 520 may be extended in parallel in one direction in the first non-flexure area NF1, bend in the first flexure area YF1, and be connected to the second non-flexure area NF2.

In an embodiment, the second flexure area YF2 may be positioned between the second non-flexure area NF2 and the third non-flexure area NF3. For example, the multilayer flexible printed circuit board 520 may be extended in parallel in one direction in the second non-flexure area NF2, be bent in the second flexure area YF2, and be connected to the third non-flexure area NF3.

In an embodiment, the bonding layer 522 may be disposed in the non-flexure areas NF1, NF2, and NF3 of the multilayer flexible printed circuit board 520. For example, the bonding layer 522 may be disposed only in the non-flexure areas NF1, NF2, and NF3 but may not be disposed in the flexure areas YF1 and YF2.

In an embodiment, one bonding layer 522 may be formed in each of the non-flexure areas NF1, NF2, and NF3 of the multilayer flexible printed circuit board 520. For example, in the non-flexure areas NF1, NF2, and NF3 of the multilayer flexible printed circuit board 520, only one bonding layer 522 may be formed between two determined pattern layers 521, but may not be formed between the remaining pattern layers 521.

In an embodiment, a position at which the bonding layer 522 is disposed (e.g., a layer at which the bonding layer 522 is disposed within the multilayer flexible printed circuit board 520) may be different according to the non-flexure areas NF1, NF2, and NF3. For example, with reference to FIG. 5, in the first non-flexure area NF1, the first bonding layer 5221 disposed between the first pattern layer 5211 and the second pattern layer 5212 may be formed. In the second non-flexure area NF2, the second bonding layer 5222 disposed between the third pattern layer 5213 and the fourth pattern layer 5214 may be formed.

Although not illustrated in FIG. 5, the multilayer flexible printed circuit board 520 may include a bonding layer 522 at a position different from that of the second non-flexure area NF2 in the third non-flexure area NF3. For example, in the third non-flexure area NF3, the first bonding layer 5221 disposed between the first pattern layer 5211 and the second pattern layer 5212 may be formed.

In FIG. 5, although it is illustrated that the bonding layer 522 is disposed only between the two pattern layers 521, the multilayer flexible printed circuit board 520 according to an embodiment may include a plurality of bonding layers 522 in the non-flexure area (e.g., NF1), and the plurality of bonding layers 522 may be positioned between different pattern layers 521. Even in the case that the multilayer flexible printed circuit board 520 includes a plurality of bonding layers 522, the bonding layer 522 may not be formed between at least two pattern layers 521. The multilayer flexible printed circuit board 520 according to an embodiment may not have at least one bonding layer 522 formed in the pattern layer 521 in the non-flexure area (e.g., NF1).

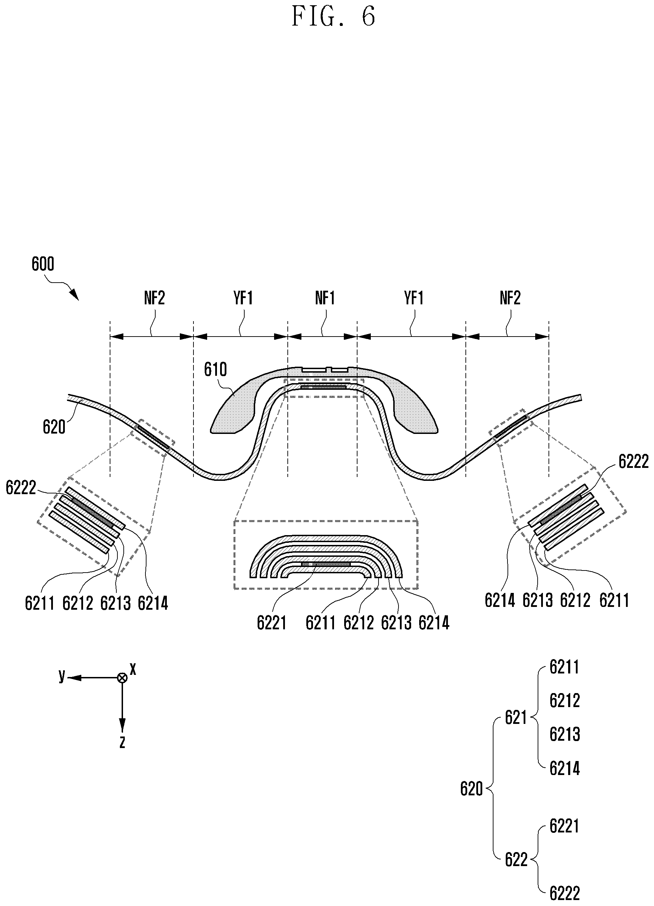

FIG. 6 is a diagram illustrating a multilayer flexible printed circuit board 620 according to an embodiment of the disclosure.

An electronic device 600 according to an embodiment may mean the electronic device 200 of FIG. 2A or the electronic device 300 of FIG. 3A or may be a device including at least a portion of the electronic device 200 of FIG. 2A and the electronic device 300 of FIG. 3A. For example, the electronic device 600 may be a foldable type device such as the electronic device 200 illustrated in FIG. 2A.

FIG. 6 is a diagram illustrating a portion of an electronic device 600 according to an embodiment. For example, FIG. 6 may be a diagram illustrating a cross section of the folding area 300A (see FIGS. 3A and 3B) of the electronic device 600. FIG. 6 is a diagram illustrating the multilayer flexible printed circuit board 620 disposed in the folding area 300A (see FIG. 3A) in an unfolded state of the electronic device 600.

In an embodiment, the electronic device 600 may include a hinge housing 610 and/or a multilayer flexible printed circuit board 620. Functions of the hinge housing 610 and the multilayer flexible printed circuit board 620 may be substantially the same as those of the hinge housing 370 and the first flexible printed circuit board 330 of FIG. 3B.

In an embodiment, the multilayer flexible printed circuit board 620 may include a pattern layer 621 and/or a bonding layer 622.

A function and material of the pattern layer 621 and the bonding layer 622 according to an embodiment may be substantially the same as those of the pattern layer 421 and the bonding layer 422 of FIG. 4. A description of the function and material of the pattern layer 621 and the bonding layer 622 may be omitted.

In an embodiment, the multilayer flexible printed circuit board 620 may include a plurality of pattern layers 621. The pattern layer 621 may include a first pattern layer 6211, a second pattern layer 6212, a third pattern layer 6213, and/or a fourth pattern layer 6214.

With reference to FIG. 6, in the multilayer flexible printed circuit board 620, the pattern layer 621 may be stacked in order of the first pattern layer 6211, the second pattern layer 6212, the third pattern layer 6213, and the fourth pattern layer 6214. For example, the second pattern layer 6212 may be stacked in one direction of the first pattern layer 6211, and the third pattern layer 6213 may be stacked in one direction of the second pattern layer 6212. The fourth pattern layer 6214 may be stacked in one direction of the third pattern layer 6213.

In an embodiment, the first pattern layer 6211 may be a layer positioned furthest from the hinge housing 610 in the multilayer flexible printed circuit board 620. The fourth pattern layer 6214 may be a layer positioned closest to the hinge housing 610 in the multilayer flexible printed circuit board 620.

In an embodiment, the first pattern layer 6211 may be a layer positioned closest to the display (e.g., the first display 230 of FIG. 3B) in the multilayer flexible printed circuit board 620. The fourth pattern layer 6214 may be a layer positioned furthest from the display (e.g., the first display 230 of FIG. 3B) in the multilayer flexible printed circuit board 620.

In an embodiment, the bonding layer 622 may include a first bonding layer 6221 and/or a second bonding layer 6222.

In an embodiment, the multilayer flexible printed circuit board 620 may include a first non-flexure area NF1, a second non-flexure area NF2, and/or a first flexure area YF1.

In an embodiment, the first non-flexure area NF1 and the second non-flexure area NF2 may be areas in which the multilayer flexible printed circuit board 620 is not bent but is extended in one direction. The first flexure area YF1 may be an area in which the multilayer flexible printed circuit board 620 is bent and extended at least in part.

In an embodiment, the second non-flexure areas NF2 and the first flexure areas YF1 each two may be formed at symmetrical positions about the first non-flexure area NF1. The first flexure area YF1 is positioned at one end and the other end of the first non-flexure area NF1. The second non-flexure area NF2 may be positioned between the first flexure areas YF1 in one direction and the other direction of the first non-flexure area NF1.

In an embodiment, the first flexure area YF1 may be positioned between the first non-flexure area NF1 and the second non-flexure area NF2. For example, the multilayer flexible printed circuit board 520 may be extended in parallel in one direction in the first non-flexure area NF1 and then bent and extended in the first flexure area YF1 to be connected to the second non-flexure area NF2.

The multilayer flexible printed circuit board 620 according to an embodiment may be extended in a shape similar to a W shape in an unfolded state of the electronic device 600. For example, the multilayer flexible printed circuit board 620 may be extended to have two convex shapes toward opposite directions of the hinge housing 610 at symmetrical positions about the first non-flexure area NF1. With reference to FIG. 6, the multilayer flexible printed circuit board 620 may be bent in a convex shape and extended in opposite directions of the hinge housing 610 in the two first flexure areas YF1.

The multilayer flexible printed circuit board 620 according to an embodiment may be extended in an inclined direction based on the first non-flexure area NF1 in the second non-flexure area NF2 in an unfolded state of the electronic device 600. For example, with reference to FIG. 6, the first non-flexure area NF1 may be extended in a direction parallel to the y-axis direction, and the second non-flexure area NF2 may be extended in a direction parallel to an inclined direction from the y-axis toward the z-axis.

In an embodiment, in the first non-flexure area NF1 and the second non-flexure area NF2 of the multilayer flexible printed circuit board 620, the bonding layer 622 may be disposed. For example, the bonding layer 622 may be disposed only in the first non-flexure area NF1 and the second non-flexure area NF2 but may not be disposed in the first flexure area YF1.

In an embodiment, in each of the non-flexure areas NF1, NF2, and NF3 of the multilayer flexible printed circuit board 620, one bonding layer 622 may be formed. For example, in the non-flexure areas NF1 and NF2 of the multilayer flexible printed circuit board 620, only one bonding layer 622 may be formed between two determined pattern layers 621 but may not be formed between the remaining pattern layers 621.

In an embodiment, a position at which the bonding layer 622 is disposed (e.g., a layer at which the bonding layer 622 is disposed within the multilayer flexible printed circuit board 620) may be different according to the non-flexure areas NF1 and NF2. For example, with reference to FIG. 6, in the first non-flexure area NF1, the first bonding layer 6221 disposed between the first pattern layer 6211 and the second pattern layer 6212 may be formed. In the second non-flexure area NF2, the second bonding layer 6222 disposed between the third pattern layer 6213 and the fourth pattern layer 6214 may be formed.

In FIG. 6, although it is illustrated that the bonding layer 622 is disposed only between two pattern layers 621, the multilayer flexible printed circuit board 620 according to an embodiment may include a plurality of bonding layers 622 in the non-flexure area (e.g., NF1), and a plurality of bonding layers 622 may be positioned between different pattern layers 621. Even in the case that the multilayer flexible printed circuit board 620 includes a plurality of bonding layers 622, the bonding layer 622 may not be formed between at least two pattern layers 621. The multilayer flexible printed circuit board 620 according to an embodiment may not have at least one bonding layer 622 formed in the pattern layer 621 in the non-flexure area (e.g., NF1).

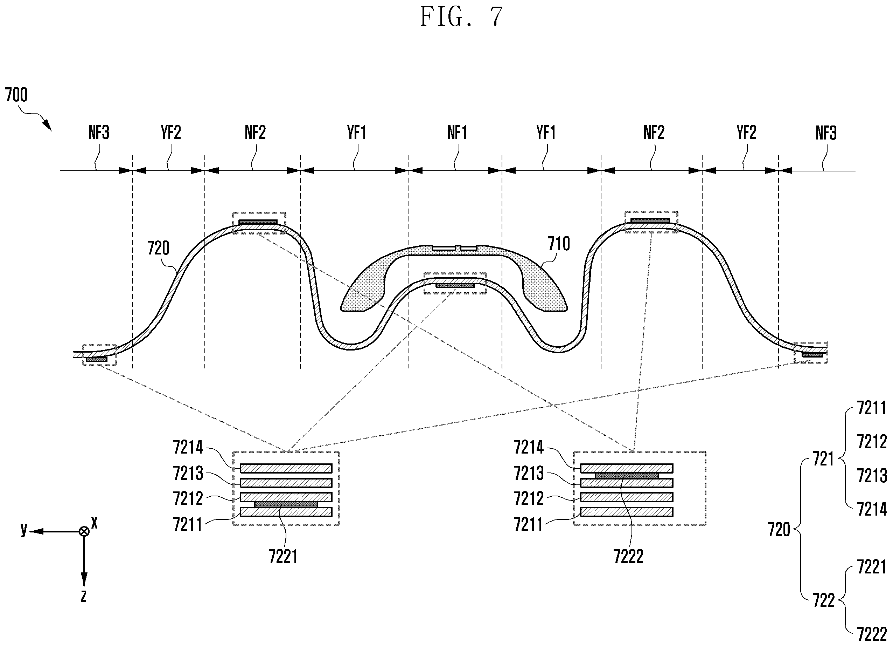

FIG. 7 is a diagram illustrating a multilayer flexible printed circuit board 720 according to an embodiment of the disclosure.

An electronic device 700 according to an embodiment may mean the electronic device 200 of FIG. 2A or the electronic device 300 of FIG. 3A or may be a device including at least a portion of the electronic device 200 of FIG. 2A and the electronic device 300 of FIG. 3A. For example, the electronic device 700 may be a foldable type device such as the electronic device 200 illustrated in FIG. 2A.

FIG. 7 is a diagram illustrating a portion of an electronic device 700 according to an embodiment. For example, FIG. 7 may be a diagram illustrating a cross section of the folding area 300A (see FIGS. 3A and 3B) of the electronic device 700. FIG. 7 is a diagram illustrating the multilayer flexible printed circuit board 720 disposed in the folding area 300A (see FIG. 3A) in an unfolded state of the electronic device 700.

In an embodiment, the electronic device 700 may include a hinge housing 710 and/or a multilayer flexible printed circuit board 720. Functions of the hinge housing 710 and the multilayer flexible printed circuit board 720 may be substantially the same as those of the hinge housing 370 and the first flexible printed circuit board 330 of FIG. 3B.

In an embodiment, the multilayer flexible printed circuit board 720 may include a pattern layer 721 and/or a bonding layer 722.

A function and material of the pattern layer 721 and the bonding layer 722 according to an embodiment may be substantially the same as those of the pattern layer 421 and the bonding layer 422 of FIG. 4. A description of the function and material of the pattern layer 721 and the bonding layer 722 may be omitted.

In an embodiment, the multilayer flexible printed circuit board 720 may include a plurality of pattern layers 721. The pattern layer 721 may include a first pattern layer 7211, a second pattern layer 7212, a third pattern layer 7213, and/or a fourth pattern layer 7214.

With reference to FIG. 7, in the multilayer flexible printed circuit board 720, the pattern layer 721 may be stacked in order of the first pattern layer 7211, the second pattern layer 7212, the third pattern layer 7213, and the fourth pattern layer 7214. For example, the second pattern layer 7212 may be stacked in one direction of the first pattern layer 7211, and the third pattern layer 7213 may be stacked in one direction of the second pattern layer 7212. The fourth pattern layer 7214 may be stacked in one direction of the third pattern layer 7213.

In an embodiment, the first pattern layer 7211 may be a layer positioned furthest from the hinge housing 710 in the multilayer flexible printed circuit board 720. The fourth pattern layer 7214 may be a layer positioned closest to the hinge housing 710 in the multilayer flexible printed circuit board 720.

In an embodiment, the first pattern layer 7211 may be a layer positioned closest to the display (e.g., the first display 230 of FIG. 3B) in the multilayer flexible printed circuit board 720. The fourth pattern layer 7214 may be a layer positioned furthest from the display (e.g., the first display 230 of FIG. 3B) in the multilayer flexible printed circuit board 720.

In an embodiment, the bonding layer 722 may include a first bonding layer 7221 and/or a second bonding layer 7222.

In an embodiment, the multilayer flexible printed circuit board 720 may include a first non-flexure area NF1, a second non-flexure area NF2, a third non-flexure area NF3, a first flexure area YF1, and/or a second flexure area YF2.

In an embodiment, the first non-flexure area NF1, the second non-flexure area NF2, and the third non-flexure area NF3 may be areas in which the multilayer flexible printed circuit board 720 is not bent and is extended in one direction. The first flexure area YF1 and the second flexure area YF2 may be areas in which the multilayer flexible printed circuit board 720 is bent and extended at least in part.

In the multilayer flexible printed circuit board 720 according to an embodiment, the second non-flexure area NF2, the third non-flexure area NF3, the first flexure area YF1, and the second flexure area YF2 each two may be formed at symmetrical positions about the first non-flexure area NF1. The first flexure area YF1 is positioned at one end and the other end of the first non-flexure area NF1. The second non-flexure area NF2 may be positioned between the first flexure areas YF1 in one direction and the other direction of the first non-flexure area NF1. The third non-flexure area NF3 may be positioned between the first flexure area YF1, the second non-flexure area NF2, and the second flexure area YF2 in one direction and the other direction of the first non-flexure area NF1.

In the multilayer flexible printed circuit board 720 according to an embodiment, the first flexure area YF1 may be positioned between the first non-flexure area NF1 and the second non-flexure area NF2. For example, the multilayer flexible printed circuit board 720 may be extended in parallel in one direction in the first non-flexure area NF1 and then be bent and extended in the first flexure area YF1 to be connected to the second non-flexure area NF2.

In the multilayer flexible printed circuit board 720 according to an embodiment, the second flexure area YF2 may be positioned between the second non-flexure area NF2 and the third non-flexure area NF3. For example, the multilayer flexible printed circuit board 520 may be extended in parallel in one direction in the second non-flexure area NF2 and then be bent and extended in the second flexure area YF2 to be connected to the third non-flexure area NF3.

The multilayer flexible printed circuit board 720 according to an embodiment may be extended so that at least a portion thereof has a shape similar to a U-shape in an unfolded state of the electronic device 700. For example, in the multilayer flexible printed circuit board 720, a portion of the multilayer flexible printed circuit board 720 in the first non-flexure area NF1 and two second non-flexure areas NF2 may have a convex shape and be extended in one direction (e.g., negative z-axis direction). The multilayer flexible printed circuit board 720 may be extended to have a convex shape in another direction (e.g., the positive z-axis direction) in the first flexure area YF1.

In the multilayer flexible printed circuit board 720 according to an embodiment, a first non-flexure area NF1 and two second non-flexure areas NF2 may be extended parallel to each other. The first non-flexure area NF1 of the multilayer flexible printed circuit board 720 may be positioned closer to the display (e.g., the first display 230 of FIG. 3B) compared to the second non-flexure area NF2.

In an embodiment, the bonding layer 722 may be disposed in the non-flexure areas NF1, NF2, and NF3 of the multilayer flexible printed circuit board 720. For example, the bonding layer 722 may be disposed only in the non-flexure areas NF1, NF2, and NF3 of the multilayer flexible printed circuit board 720 but may not be disposed in the flexure areas YF1 and YF2.

In an embodiment, one bonding layer 722 may be formed in each of the non-flexure areas NF1, NF2, and NF3 of the multilayer flexible printed circuit board 720. For example, in the non-flexure areas NF1, NF2, and NF3 of the multilayer flexible printed circuit board 720, only one bonding layer 722 may be formed between two determined pattern layers 721 but may not be formed between the remaining pattern layers 721.

In an embodiment, in two non-flexure areas NF1, NF2, and NF3 positioned between one flexure areas YF1 and YF2, the bonding layer 722 may be disposed in different layers. The fact that the bonding layer 722 is disposed in different layers may mean that the bonding layer 722 is disposed between different pattern layers 721. For example, in the first non-flexure area NF1 and the second non-flexure area NF2 positioned between the first flexure areas YF1, the bonding layers 722 may be disposed in different layers. In the first non-flexure area NF1, the first bonding layer 7221 disposed between the first pattern layer 7211 and the second pattern layer 7212 may be formed. In the second non-flexure area NF2, the second bonding layer 7222 disposed between the third pattern layer 7213 and the fourth pattern layer 7214 may be formed. Likewise, in the second non-flexure area NF2 and the third non-flexure area NF3 positioned between the second flexure areas YF2, the bonding layers 722 may be disposed in different layers. In the third non-flexure area NF3, the second bonding layer 7222 disposed between the first pattern layer 7211 and the second pattern layer 7212 may be formed.

In FIG. 7, although it is illustrated that the bonding layer 722 is disposed only between two pattern layers 721, the multilayer flexible printed circuit board 720 according to an embodiment may include a plurality of bonding layers 722 in the non-flexure area (e.g., NF1), and the plurality of bonding layers 722 may be positioned between different pattern layers 721. Even in the case that the multilayer flexible printed circuit board 720 includes a plurality of bonding layers 722, the bonding layer 722 may not be formed between at least two pattern layers 721. The multilayer flexible printed circuit board 720 according to an embodiment may not have at least one bonding layer 722 formed in the pattern layer 721 in the non-flexure area (e.g., NF1).

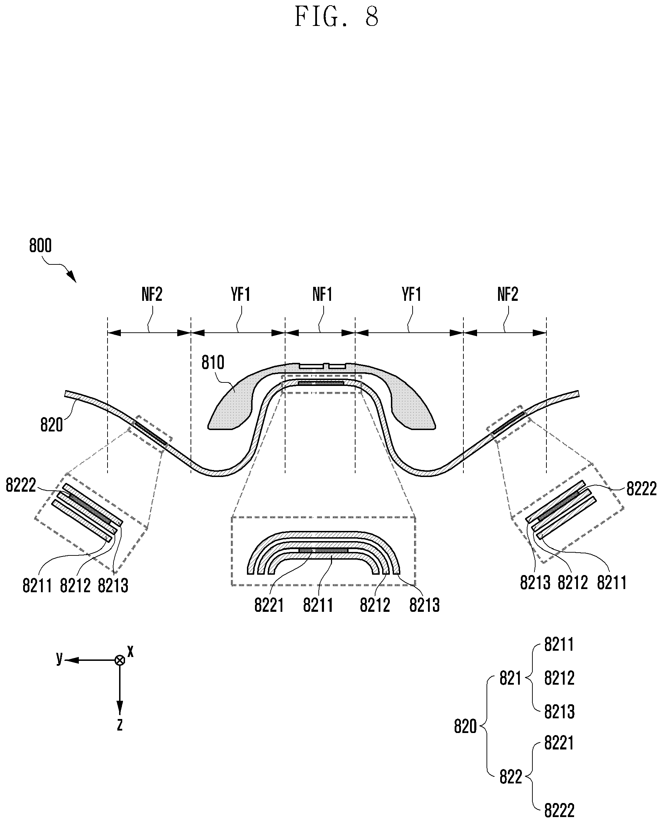

FIG. 8 is a diagram illustrating a multilayer flexible printed circuit board 820 according to an embodiment of the disclosure.

The multilayer flexible printed circuit board 820 according to an embodiment illustrated in FIG. 8 may be a board extended in substantially the same shape as that of the multilayer flexible printed circuit board 620 of FIG. 6.

Because the multilayer flexible printed circuit board 820 according to an embodiment illustrated in FIG. 8 has substantially the same shape and function as those of the multilayer flexible printed circuit board 620 of FIG. 6, a description of substantially the same constitution as that of the multilayer flexible printed circuit board 620 of FIG. 6 may be omitted.

The multilayer flexible printed circuit board 820 according to an embodiment illustrated in FIG. 8 may include the smaller number of pattern layers 821 than those of the multilayer flexible printed circuit board 620 of FIG. 6. For example, the multilayer flexible printed circuit board 820 of FIG. 8 may include three pattern layers 821.

In an embodiment, the multilayer flexible printed circuit board 820 may include a pattern layer 821 and/or a bonding layer 822.

In an embodiment, the pattern layer 821 may include a first pattern layer 8211, a second pattern layer 8212, and/or a third pattern layer 8213.

In an embodiment, the bonding layer 822 may include a first bonding layer 8221 and/or a second bonding layer 8222.

In an embodiment, a position at which the bonding layer 822 is disposed (e.g., a layer at which the bonding layer 822 is disposed within the multilayer flexible printed circuit board 820) may be different according to the non-flexure areas NF1 and NF2. For example, with reference to FIG. 8, in a first non-flexure area NF1, the first bonding layer 8221 disposed between the first pattern layer 8211 and the second pattern layer 8212 may be formed. In a second non-flexure area NF2, the second bonding layer 8222 disposed between the second pattern layer 8212 and the third pattern layer 8213 may be formed.

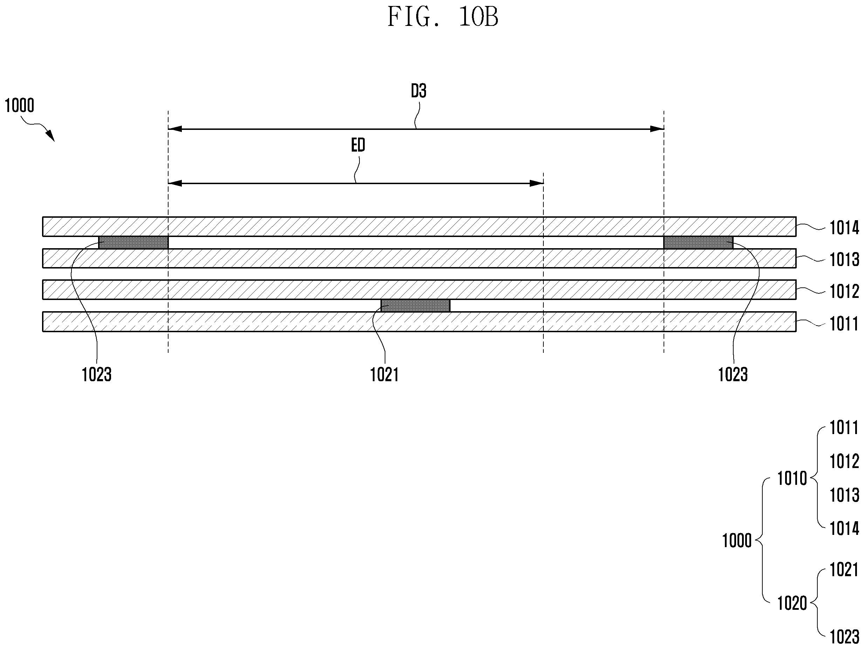

In an embodiment, in the case that the bonding layers 522, 622, 722, and 822 are positioned in different layers (e.g., between different pattern layers) in non-flexure areas (e.g., NF1 and NF2) adjacent to each other, the stress applied to the multilayer flexible printed circuit boards 520, 620, 720, and 820 may be reduced, and the multilayer flexible printed circuit board 520 may easily maintain a determined shape. For example, in the case that the bonding layers 522, 622, 722, and 822 are positioned in different layers in non-flexure areas (e.g., NF1 and NF2) adjacent to each other, an effective separation distance ED (see FIG. 10B) between the bonding layers 522, 622, 722, and 822 increases; thus, the stress applied to the multilayer flexible printed circuit boards 520, 620, 720, and 820 may reduce, and the multilayer flexible printed circuit boards 520, 620, 720, and 820 may easily maintain a determined shape.

Because the multilayer flexible printed circuit boards 520, 620, 720, and 820 according to an embodiment dispose bonding layers 522, 622, 722, and 822 in different layers (e.g., between different pattern layers) in non-flexure areas (e.g., NF1 and NF2) positioned between flexure areas (e.g., YF1), the stress applied to the multilayer flexible printed circuit board 520, 620, 720, and 820 may reduce, and the multilayer flexible printed circuit boards 520, 620, 720, and 820 may easily maintain a determined shape.

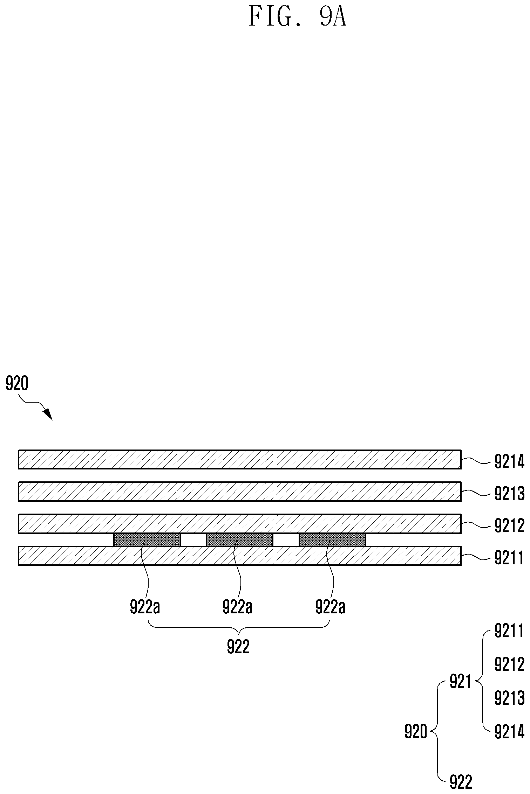

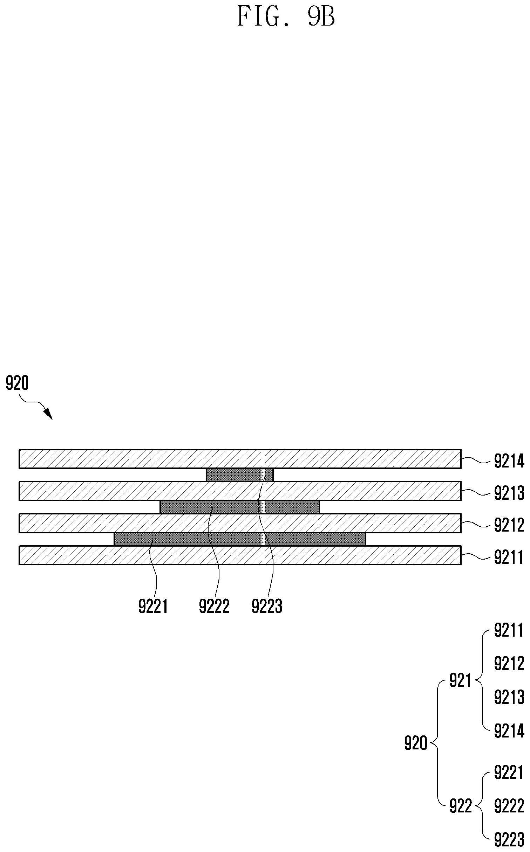

FIGS. 9A and 9B are diagrams illustrating a multilayer flexible printed circuit board 920 according to an embodiment of the disclosure.

The multilayer flexible printed circuit board 920 according to an embodiment illustrated in FIGS. 9A and 9B may be a multilayer flexible printed circuit board 920 disposed in a non-flexure area NF (e.g., see FIG. 4).

With reference to FIGS. 9A and 9B, the multilayer flexible printed circuit board 920 may include a pattern layer 921 and/or a bonding layer 922.

In an embodiment, the multilayer flexible printed circuit board 920 may include a plurality of pattern layers 921. For example, the pattern layer 921 may include a first pattern layer 9211, a second pattern layer 9212, a third pattern layer 9213, and/or a fourth pattern layer 9214.

In an embodiment, the first pattern layer 9211 may be a layer positioned closest to the display (e.g., the first display 230 of FIG. 3B) in the multilayer flexible printed circuit board 920. The fourth pattern layer 9214 may be a layer positioned furthest from the display (e.g., the first display 930 of FIG. 2A) in the multilayer flexible printed circuit board 920.

In describing the multilayer flexible printed circuit board 920 according to an embodiment of the disclosure, a height direction of the multilayer flexible printed circuit board 920 may mean a direction in which a plurality of pattern layers 921 are stacked. A length direction of the multilayer flexible printed circuit board 920 may mean a direction perpendicular to a height direction thereof and in which the multilayer flexible printed circuit board 920 is extended relatively long.

In an embodiment, the bonding layer 922 may include a plurality of bonding parts 922a. The bonding part 922a may be disposed to be extended from a portion between the pattern layers 921. A length in which the bonding part 922a is extended in the length direction of the multilayer flexible printed circuit board 920 may be shorter than a length in which one bonding layer (e.g., the first bonding layer 9221) is extended in the length direction of the multilayer flexible printed circuit board 920.

With reference to FIG. 9A, in the multilayer flexible printed circuit board 920 according to an embodiment, a plurality of bonding parts 922a may be disposed to be spaced apart from each other between two pattern layers 921. For example, a plurality of bonding parts 922a may be disposed to be spaced apart between the first pattern layer 9211 and the second pattern layer 9212 in the length direction of the multilayer flexible printed circuit board 920. Thus, in certain embodiments, a plurality of bonding layers (or plurality of bonding parts 922a) may be arranged to bond together a plurality, or series, of portions of an adjacent pair of pattern layers, with gaps (unbonded portions) between.

With reference to FIG. 9B, in the multilayer flexible printed circuit board 920 according to an embodiment, the bonding layer 922 may be disposed between each pattern layer 921. In other words, the device may comprise a plurality of bonding layers, each bonding layer being arranged between, and bonding together, a respective pair of adjacent pattern layers. The plurality of bonding layers may have the same length as each other, or may have different lengths. For example, a first bonding layer 9221 may be disposed between the first pattern layer 9211 and the second pattern layer 9212, and a second bonding layer 9222 may be disposed between the second pattern layer 9212 and the third pattern layer 9213. A third bonding layer 9223 may be disposed between the third pattern layer 9213 and the fourth pattern layer 9214.

With reference to FIG. 9B, in the multilayer flexible printed circuit board 920 according to an embodiment, a length of the bonding layer 922 (e.g., a length in which the bonding layer 922 is extended in the length direction of the multilayer flexible printed circuit board 920) may be formed long as the bonding layer 922 is positioned adjacent to the first pattern layer 9211. For example, the length of the first bonding layer 9221 may be longer than that of the second bonding layer 9222. The length of the second bonding layer 9222 may be longer than that of the third bonding layer 9223.

As the length of the bonding layer 922 disposed in the multilayer flexible printed circuit board 920 becomes shorter, the multilayer flexible printed circuit board 920 may be easily bent. Because the multilayer flexible printed circuit board 920 according to an embodiment includes a bonding layer 922 whose extended length is relatively short, the multilayer flexible printed circuit board 920 may be easily bent compared to the case that one bonding layer 922 is disposed to be extended long.

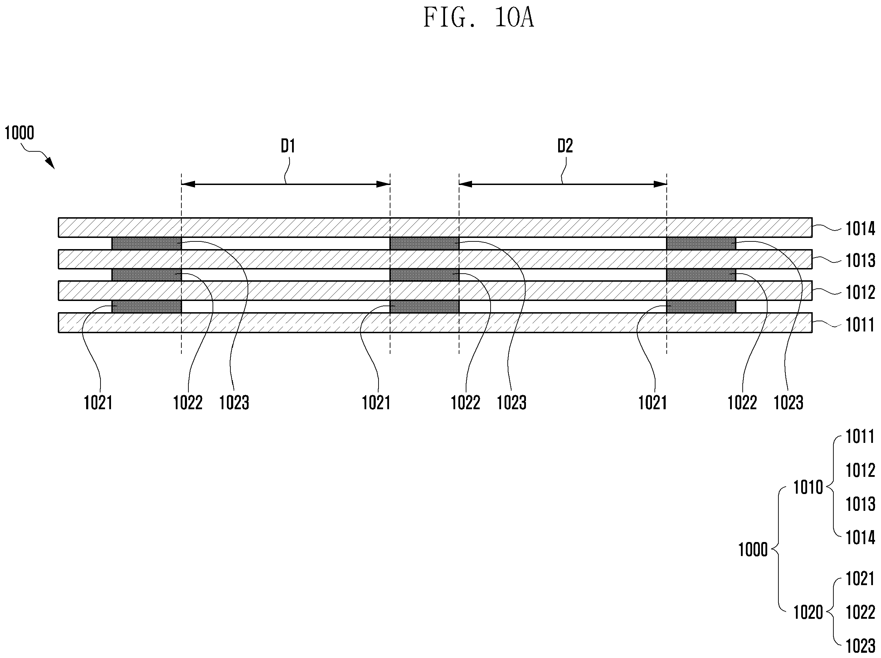

FIGS. 10A and 10B are diagrams illustrating separation distances D1 and D2 and an effective separation distance ED between bonding layers 1020 according to an embodiment of the disclosure.

A multilayer flexible printed circuit board 1000 according to an embodiment illustrated in FIGS. 10A and 10B may be a multilayer flexible printed circuit board 1000 disposed in the folding area 300A (e.g., see FIG. 3A) of the electronic device 300 (see FIG. 3A).

With reference to FIGS. 10A and 10B, the multilayer flexible printed circuit board 1000 may include a pattern layer 1010 and/or a bonding layer 1020.

In an embodiment, the multilayer flexible printed circuit board 1000 may include a plurality of pattern layers 1010. For example, the pattern layer 1010 may include a first pattern layer 1011, a second pattern layer 1012, a third pattern layer 1013, and/or a fourth pattern layer 1014.

In an embodiment, the bonding layer 1020 may include a first bonding layer 1021, a second bonding layer 1022, and/or a third bonding layer 1023. The first bonding layer 1021 may be a bonding layer 1020 disposed between the first pattern layer 1011 and the second pattern layer 1012. The second bonding layer 1022 may be a bonding layer 1020 disposed between the second pattern layer 1012 and the third pattern layer 1013. The third bonding layer 1023 may be a bonding layer 1020 disposed between the third pattern layer 1013 and the fourth pattern layer 1014.

In an embodiment, a distance between bonding layers 1020 disposed in the same pattern layer 1010 may be formed differently according to the bonding layer 1020 included in the multilayer flexible printed circuit board 1000. For example, with reference to FIG. 10A, in the case that the multilayer flexible printed circuit board 1000 includes all of the first bonding layer 1021, the second bonding layer 1022, and the third bonding layer 1023, and in the case that only a portion of the first bonding layer 1021, the second bonding layer 1022, and the third bonding layer 1023 is included, a distance between the bonding layers 1020 disposed in the same pattern layer 1010 may be formed differently.

With reference to FIG. 10A, in the case that the multilayer flexible printed circuit board 1000 includes a first bonding layer 1021, a second bonding layer 1022, and a third bonding layer 1023, a distance between the bonding layers 1020 disposed in the same pattern layer 1010 may be formed as a first separation distance D1 or a second separation distance D2.

With reference to FIG. 10B, in the case that the multilayer flexible printed circuit board 1000 includes a portion (e.g., the first bonding layer 1021 and the third bonding layer 1023) of the bonding layer 1020, a distance between the bonding layers 1020 disposed in the same pattern layer 1010 may be formed as a third separation distance D3. For example, two third bonding layers 1023 disposed between the third pattern layer 1013 and the fourth pattern layer 1014 may be disposed to be spaced apart from each other by a third separation distance D3.

In an embodiment, the stress applied to the multilayer flexible printed circuit board 1000 may vary based on a distance between the bonding layers 1020 disposed in the same pattern layer 1010. For example, as a separation distance between the bonding layers 1020 increases, the stress applied to the multilayer flexible printed circuit board 1000 may reduce. When the stress applied to the multilayer flexible printed circuit board 1000 reduces, the lifespan of the multilayer flexible printed circuit board 1000 may increase.

In the case that another bonding layer 1020 disposed in another pattern layer 1010 is positioned between two bonding layers 1020 disposed in one pattern layer 1010, the stress applied to the multilayer flexible printed circuit board 1000 may vary based on an effective separation distance ED formed shorter than a separation distance (e.g., D3) between two bonding layers 1020. For example, with reference to FIG. 10B, in the case that the first bonding layer 1021 positioned at a different layer from the third bonding layer 1023 is positioned between two third bonding layers 1023, the effective separation distance ED between the third bonding layers 1023 may be formed shorter than the third separation distance D3. The stress applied to the multilayer flexible printed circuit board 1000 of FIG. 10B may be based on the effective separation distance ED.

In an embodiment, the effective distance ED illustrated in FIG. 10B may be longer than the first distance D1 and the second distance D2 illustrated in FIG. 10A. Because the stress applied to the multilayer flexible printed circuit board 1000 is inversely proportional to a separation distance or an effective separation distance between the bonding layers 1020, the stress applied to the multilayer flexible printed circuit board 1000 of FIG. 10A may be greater than that applied to the multilayer flexible printed circuit board 1000 of FIG. 10B. Therefore, it may be advantageous in improving the lifespan of the multilayer flexible printed circuit board 1000 to dispose the bonding layer 1020 only between some pattern layers 1010 in the same form as that of the multilayer flexible printed circuit board 1000 of FIG. 10B rather than disposing the bonding layer 1020 between all pattern layers 1010 in the same form as that of the multilayer flexible printed circuit board 1000 of FIG. 10A.

The multilayer flexible printed circuit boards 520, 620, 720, and 820 according to an embodiment of the disclosure may dispose a bonding layer 1020 only between some pattern layers 1010 in the same form as that of the multilayer flexible printed circuit board 1000 of FIG. 10B, thereby improving the lifespan of the multilayer flexible printed circuit board 1000.

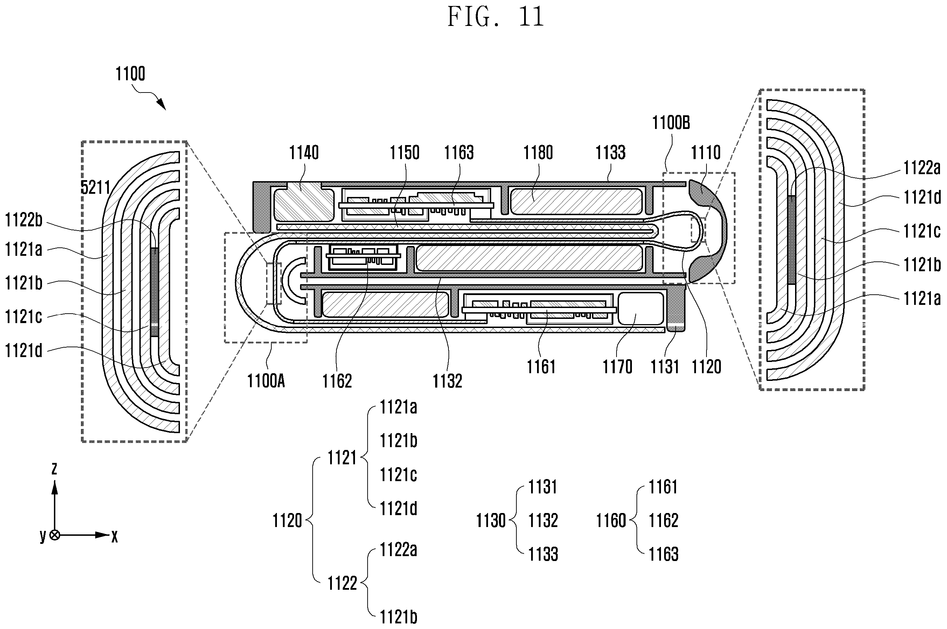

FIG. 11 is a diagram illustrating an electronic device 1100 according to an embodiment of the disclosure.

In describing the electronic device 1100 according to an embodiment of the disclosure, a length direction of the electronic device 1100 may mean the y-axis direction, and a width direction of the electronic device 1100 may mean the x-axis direction. A height direction of the electronic device 1100 may mean the z-axis direction.

The electronic device 1100 according to an embodiment of the disclosure may be a multi-foldable type device. For example, the electronic device 1100 may be a device including a plurality of folding areas 1100A and 1100B in which the electronic device 1100 may be folded. For example, with reference to FIG. 11, the electronic device 1100 may include a first folding area 1100A and/or a second folding area 1100B. In the first folding area 1100A and the second folding area 1100B, the electronic device 1100 may be constituted to be foldable about a longitudinal axis (e.g., y-axis direction). The electronic device 1100 may be folded in opposite directions in the first folding area 1100A and the second folding area 1100B.

FIG. 11 is a diagram illustrating a state in which a multi-foldable type electronic device 1100 is completely folded in folding areas 1100A and 1100B and in which at least a portion of the display 1150 of the electronic device 1100 is overlapped with each other.

FIG. 11 is a diagram illustrating the electronic device 1100 in a cross section perpendicular to a length direction (e.g., y-axis direction) according to an embodiment.

The electronic device 1100 according to an embodiment of the disclosure may include a hinge housing 1110, a multilayer flexible printed circuit board 1120, a housing 1130, a camera 1140, a display 1150, a printed circuit board 1160, a speaker 1170, a battery 1180, and/or a hinge (e.g., 390, see FIG. 3A).

In an embodiment, the housing 1130 may include a first housing 1131, a second housing 1132, and/or a third housing 1133.

In an embodiment, the electronic device 1100 may include a first folding area 1100A and/or a second folding area 1100B. In the first folding area 1100A, a first hinge (e.g., 390, see FIG. 3A) for rotatably connecting a first housing 1131 and a second housing 1132 with respect to each other may be positioned. In the second folding area 1100B, a second hinge (e.g., 390, see FIG. 3A)for rotatably connecting the second housing 1132 and a third housing 1133 with respect to each other may be positioned.

In an embodiment, the printed circuit board 1160 may include a first printed circuit board 1161, a second printed circuit board 1162, and/or a third printed circuit board 1163.

In an embodiment, in the first printed circuit board 1161, the second printed circuit board 1162, and/or the third printed circuit board 1163, the processor 120 (see FIG. 1) and/or the memory 130 (see FIG. 1) may be disposed.

In an embodiment, the hinge housing 1110 may be disposed to enclose at least a portion of the folding areas 1100A and 1100B at an outer edge. The hinge housing 1110 may have substantially the same function as that of the hinge housing 241 of FIG. 2D.

In an embodiment, the camera 1140, the speaker 1170, and the battery 1180 may mean the camera module 180, the sound output module 155, and the battery 189, respectively of FIG. 1.

In an embodiment, the display 1150 may mean the display module 160 of FIG. 1 or may include at least a portion of the display module 160. For example, the display 1150 may be a flexible display including a bendable material.

In an embodiment, the first printed circuit board 1161 may be disposed in the first housing 1131. The second printed circuit board 1162 may be disposed in the second housing 1132. The third printed circuit board 1163 may be disposed in the third housing 1133.

In an embodiment, the multilayer flexible printed circuit board 1120 may perform a function of electrically connecting the first printed circuit board 1161, the second printed circuit board 1162, and/or the third printed circuit board 1163.

In an embodiment, the multilayer flexible printed circuit board 1120 may include a plurality of pattern layers 1121. The pattern layer 1121 may include a first pattern layer 1121a, a second pattern layer 1121b, a third pattern layer 1121c, and/or a fourth pattern layer 1121d.

In an embodiment, the first pattern layer 1121a may be a layer positioned closest to the display 1150 in the multilayer flexible printed circuit board 1120. The fourth pattern layer 1121d may be a layer positioned furthest from the display 1150 in the multilayer flexible printed circuit board 1120.

With reference to FIG. 11, in the multilayer flexible printed circuit board 1120, the pattern layer 1121 may be stacked in order of the first pattern layer 1121a, the second pattern layer 1121b, the third pattern layer 1121c, and the fourth pattern layer 1121d. For example, the second pattern layer 1121b may be stacked in one direction of the first pattern layer 1121a, and the third pattern layer 1121c may be stacked in one direction of the second pattern layer 1121b. The fourth pattern layer 1121d may be stacked in one direction of the third pattern layer 1121c.

In an embodiment, the bonding layer 1122 may include a first bonding layer 1122a and/or a second bonding layer 1122b. The first bonding layer 1122a may be a bonding layer 1122 disposed between the first pattern layer 1121a and the second pattern layer 1121b. The second bonding layer 1122b may be a bonding layer 1122 disposed between the third pattern layer 1121c and the fourth pattern layer 1121d.

A function and material of the pattern layer 1121 and the bonding layer 1122 according to an embodiment may be substantially the same as those of the pattern layer 421 and the bonding layer 422 of FIG. 4. A description of the function and material of the pattern layer 1121 and the bonding layer 1122 may be omitted.

In the multilayer flexible printed circuit board 1120 according to an embodiment, a position in which the bonding layer 1122 is disposed may be different according to the folding areas 1100A and 1100B. For example, in the first folding area 1100A, the multilayer flexible printed circuit board 1120 may include a second bonding layer 1122b disposed between the third pattern layer 1121c and the fourth pattern layer 1121d. For example, in the second folding area 1100B, the multilayer flexible printed circuit board 1120 may include a first bonding layer 1122a disposed between the first pattern layer 1121a and the second pattern layer 1121b.

By differently forming positions of layers in which the bonding layer 1122 is disposed according to the folding areas 1100A and 1100B, the electronic device 1100 according to an embodiment can improve the lifespan of the multilayer flexible printed circuit board 1120 and enable the flexible printed circuit board 1120 to maintain a determined design shape.

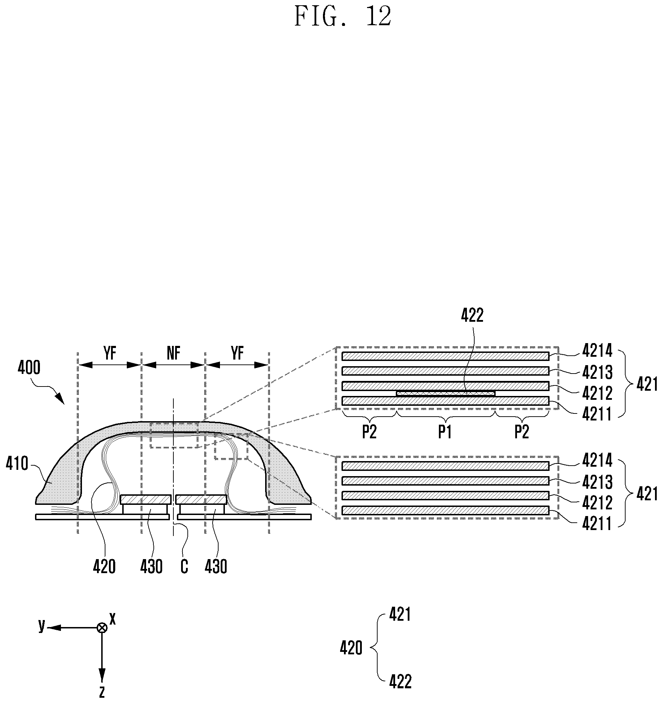

FIG. 12 is a diagram illustrating an electronic device 400 including a bonding layer 422 disposed in a first area P1 according to an embodiment of the disclosure.

In describing the electronic device 400 according to an embodiment of the disclosure, a width direction of the electronic device 400 may mean the x-axis direction, and a length direction thereof may mean the y-axis direction. A height direction of the electronic device 400 may mean the z-axis direction.

The electronic device 400 illustrated in FIG. 12 may mean the electronic device 300 of FIG. 3A or may include at least a portion of the electronic device 300 of FIG. 3A.

The electronic device 400 illustrated in FIG. 12 may include the same constitution as that of the electronic device 400 of FIG. 4. In a description of the constitution of the electronic device 400 of FIG. 12, a description of the same constitution as that of the electronic device 400 of FIG. 4 may be omitted.

With reference to FIG. 12, the electronic device 400 according to an embodiment may include a hinge housing 410, a multilayer flexible printed circuit board 420, and/or a support member 430.

In an embodiment, the multilayer flexible printed circuit board 420 may include a plurality of pattern layers 421. The pattern layer 421 may include a first pattern layer 4211, a second pattern layer 4212, a third pattern layer 4213, and/or a fourth pattern layer 4214.

In an embodiment, the non-flexure area NF may include a first area P1 and/or a second area P2. The first area P1 may be an area requiring reduction of a path loss of the multilayer flexible printed circuit board 420. The first area P1 may be an area in which a radio frequency (RF) signal wire is disposed.

In an embodiment, the bonding layer 422 may be formed only in a predetermined area of the non-flexure area NF. For example, with reference to FIG. 12, the bonding layer 422 may be formed only in the first area P1 of the non-flexure area NF.

In an embodiment, the first area P1 of the multilayer flexible printed circuit board 420 may include a bonding layer 422, and the second area P2 of the multilayer flexible printed circuit board 420 may not include a bonding layer 422. For example, in the first area P1 of the multilayer flexible printed circuit board 420, the bonding layer 422 may be disposed between the first pattern layer 4211 and the second pattern layer 4212.

The multilayer flexible printed circuit board 420 according to an embodiment includes a bonding layer 422 only in the first area P1; thus, the multilayer flexible printed circuit board 420 may be easily bent.

The multilayer flexible printed circuit board 420 according to an embodiment may dispose a bonding layer 422 in an area (e.g., first area P1) requiring reduction of a path loss, thereby reducing a path loss thereof.

In the multilayer flexible printed circuit boards 420, 520, 620, 720, 820, 920, 1120, and 1220 according to an embodiment of the disclosure, a length direction of the multilayer flexible printed circuit board (e.g., 420) is the multilayer flexible printed circuit may mean a direction in which the multilayer flexible printed circuit board (e.g., 420) is extended long. A height direction of the multilayer flexible printed circuit board (e.g., 420) may mean a direction substantially perpendicular to a length direction thereof and one surface of each layer (e.g., 421, 422) included in the multilayer flexible printed circuit board (e.g., 420).

The electronic device 300 according to an embodiment of the disclosure may include a first housing 310 in which a first printed circuit board 350 is disposed, a second housing 320 in which a second printed circuit board 360 is disposed, a hinge 390 for rotatably connecting the first housing 310 and the second housing 320 with respect to each other, and a multi-layer flexible printed circuit board 420 for connecting the first printed circuit board 350 and the second printed circuit board 360.

The multilayer flexible printed circuit board 420 according to an embodiment of the disclosure may be disposed through the folding area 300A of the electronic device 300 in which the hinge 390 is positioned and include a plurality of pattern layers 421 stacked in a height direction of the multilayer flexible printed circuit board 420 and a bonding layer 422 for bonding a portion between at least two pattern layers 420 of the plurality of pattern layers 421, and in the folding area 300A, the multilayer flexible printed circuit board 420 may include at least one flexure area YF in which the multilayer flexible printed circuit board 420 is bent and extended (i.e. is flexed, when the device is folded and unfolded), and a non-flexure area NF (for example between the flexure areas YF).

In an embodiment, in the folding area 300A of the electronic device 300, at least one bonding layer 422 may be formed at least in part only in the (or a) non-flexure area NF.

In an embodiment, it may be characterized that the non-flexure area NF is flat or has a curvature smaller than that of the (or each) flexure area YF.

In an embodiment, the (or each) bonding layer 422 may be formed only between two pattern layers 421 among the plurality of pattern layers 421 in the non-flexure area NF.

In an embodiment, the multilayer flexible printed circuit board 420 may not have at least one bonding layer 422 formed between the pattern layers 421 in the non-flexure area NF. In other words, in the or each non-flexure area, there may be no adjacent pair of pattern layers bonded together.

In an embodiment, in the folding area 300A, the multilayer flexible printed circuit board 520 may include a plurality of non-flexure areas NF, and in two non-flexure areas NF 1 and NF2 positioned between the flexure areas YF, the bonding layer 522 may be disposed between different pattern layers 521.

In an embodiment, the electronic device 300 may further include a display 230 disposed in the first housing 310 and the second housing 320, and the bonding layer 422 may be disposed between two pattern layers 421 positioned closest to the display 230 among the plurality of pattern layers 421 in the non-flexure area NF.

In an embodiment, the non-flexure area NF may include a first non-flexure area NF1 whose at least a portion is positioned at a center C (see FIG. 5) of the folding area, and a second non-flexure area NF2 positioned symmetrically about the first non-flexure area NF1.

In an embodiment, the bonding layer 5221 formed in the first non-flexure area NF1 and the bonding layer 5222 formed in the second non-flexure area NF2 may be positioned between different pattern layers 521.

In an embodiment, the bonding layer may include a plurality of bonding parts 922a, and the plurality of bonding parts 922a may be disposed to be spaced apart in a length direction of the multilayer flexible printed circuit board 920 in the non-flexure area NF.

In an embodiment, the pattern layer 921 may include a first pattern layer 9211, a second pattern layer 9212, and a third pattern layer 9213 stacked in a height direction of the multilayer flexible printed circuit board 920, and the bonding layer 922 may include a first bonding layer 9221 disposed between the first pattern layer 9211 and the second pattern layer 9212 and a second bonding layer 9222 disposed between the second pattern layer 9212 and the third pattern layer 9213, and a length of the first bonding layer 9221 may be longer than that of the second bonding layer 9222.

In an embodiment, in the folding area 300A, at least one bonding layer 422 may be formed only in a predetermined area of the non-flexure area NF.

In an embodiment, a predetermined area in which at least one bonding layer 422 is formed may be an area requiring reduction of a path loss.

In an embodiment, a predetermined area in which at least one bonding layer 422 is formed may be an area in which a radio frequency (RF) signal wire is disposed.

In an embodiment, the pattern layer 421 may be composed of a plurality of layers and include a layer including an insulator and a layer including a conductive pattern.

In an embodiment, the bonding layer 422 may have a predetermined thickness between two pattern layers 421 and be extended in a length direction of the multilayer flexible printed circuit board 420.

In an embodiment, flexibility of the non-flexure area NF in which the bonding layer 422 is formed may be lower than that of the flexure area YF.

In an embodiment, the multilayer flexible printed circuit board 420 may include a bonding layer 422 formed in a portion between the pattern layers 421 in areas other than the folding area 300A.

The electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, or a home appliance. The electronic devices according to embodiments of the disclosure are not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with an embodiment of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

An embodiment as set forth herein may be implemented as software (e.g., the program 140) including one or more instructions that are stored in a storage medium (e.g., the internal memory 136 or the external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., module or program) of the above-described components may include a singular or a plurality of entities, and some of the plurality of entities may be separately disposed in any other component. According to an embodiment, one or more components or operations among the above-described components may be omitted, or one or more other components or operations may be added. Alternatively or additionally, a plurality of components (e.g., module or program) may be integrated into one component. In this case, the integrated component may perform one or more functions of each component of the plurality of components identically or similarly to those performed by the corresponding component among the plurality of components prior to the integration.

According to an embodiment, operations performed by a module, program, or other component may be executed sequentially, in parallel, repeatedly, or heuristically, or one or more of the operations may be executed in a different order or omitted, or one or more other operations may be added.

## Claims

1. An electronic device (300), comprising:
a first housing (310) in which a first printed circuit board (350) is disposed;
a second housing (320) in which a second printed circuit board (360) is disposed;
a hinge (390) configured to rotatably connect the first housing and the second housing with respect to each other; and
a multilayer flexible printed circuit board (420) configured to connect the first printed circuit board and the second printed circuit board and disposed through a folding area (300A) of the electronic device in which the hinge is positioned, wherein the multilayer flexible printed circuit board (420) comprises a plurality of pattern layers (421) stacked in a height direction of the multilayer flexible printed circuit board and at least one bonding layer (422) configured to bond a portion between at least two pattern layers of the plurality of pattern layers,
wherein a portion of the multilayer flexible printed circuit board corresponding to the hinge comprises a non-flexure area (NF), and a flexure area (YF) in which the multilayer flexible printed circuit board is bent, the flexure area (YF) comprising a first flexure area extending from one end of the non-flexure area (NF), and a second flexure area extending from the other end of the non-flexure area (NF),
wherein the at least one bonding layer is formed at least partially on the non-flexure area and wherein the at least one bonding layer is not formed on the first flexure area and second flexure area.

2. The electronic device of claim 1, wherein the non-flexure area is flat or has a curvature smaller than that of the flexure area.

3. The electronic device of claim 1 or 2, wherein the bonding layer is formed only between two pattern layers among the plurality of pattern layers in the non-flexure area.

4. The electronic device of any one of claims 1 to 3, wherein in the portion of the multilayer flexible printed circuit board (420),
the multilayer flexible printed circuit board comprises a plurality of non-flexure areas, and
the bonding layer is disposed between different pattern layers in two of the non-flexure areas positioned between the flexure areas.

5. The electronic device of any one of claims 1 to 4, further comprising a display (230) disposed in the first housing and the second housing,
wherein the bonding layer is disposed between the two pattern layers positioned closest to the display among the plurality of pattern layers in the non-flexure area.

6. The electronic device of any one of claims 1 to 5, wherein the non-flexure area comprises:
a first non-flexure area (NF1) whose at least a portion is positioned at a center (C) of the folding area; and
second (NF2) and third (NF3) non-flexure areas positioned symmetrically about the first non-flexure area.

7. The electronic device of claim 6, wherein the bonding layer formed in the first non-flexure area and the bonding layer formed in the second non-flexure area are positioned between different pattern layers.

8. The electronic device of any one of claims 1 to 7, wherein in the non-flexure area, the bonding layer comprises a plurality of bonding parts (922a), and
the plurality of bonding parts are disposed to be spaced apart in a length direction of the multilayer flexible printed circuit board.

9. The electronic device of any one of claims 1 to 8, wherein the plurality of pattern layers comprise a first pattern layer (9211), a second pattern layer (9212), and a third pattern layer (9213) stacked in a height direction of the multilayer flexible printed circuit board,
wherein the bonding layer comprises:
a first bonding layer (9221) disposed between the first pattern layer and the second pattern layer; and
a second bonding layer (9222) disposed between the second pattern layer and the third pattern layer,
wherein a length of the first bonding layer is longer than that of the second bonding layer.

10. The electronic device of any one of claims 1 to 9, wherein in the portion of the multilayer flexible printed circuit board (420), the at least one bonding layer is formed only in a predetermined area (P1) of the non-flexure area.

11. The electronic device of claim 10, wherein the predetermined area is an area requiring reduction of a path loss.

12. The electronic device of claim 10, wherein the predetermined area is an area in which a radio frequency, RF, signal wire is disposed.

13. The electronic device of any one of claims 1 to 12, wherein at least one of the pattern layers is composed of a plurality of layers and comprises a layer including an insulator and a layer including a conductive pattern.

14. The electronic device of any one of claims 1 to 13, wherein the bonding layer has a predetermined thickness between two of the pattern layers and is extended in a length direction of the multilayer flexible printed circuit board.

## Patentansprüche

1. Elektronische Vorrichtung (300), umfassend:
ein erstes Gehäuse (310), in dem eine erste Leiterplatte (350) angeordnet ist;
ein zweites Gehäuse (320), in dem eine zweite Leiterplatte (360) angeordnet ist;
ein Scharnier (390), das dazu konfiguriert ist, das erste Gehäuse und das zweite Gehäuse in Bezug zueinander drehend zu verbinden; und
eine mehrschichtige flexible Leiterplatte (420), die dazu konfiguriert ist, die erste Leiterplatte und die zweite Leiterplatte zu verbinden und durch einen Faltbereich (300A) der elektronischen Vorrichtung angeordnet ist, in dem das Scharnier positioniert ist, wobei die mehrschichtige flexible Leiterplatte (420) eine Vielzahl von Musterschichten (421), die in einer Höhenrichtung der mehrschichtigen flexiblen Leiterplatte gestapelt sind, und zumindest eine Bindungsschicht (422) umfasst, die dazu konfiguriert ist, einen Abschnitt zwischen zumindest zwei Musterschichten der Vielzahl von Musterschichten zu binden,
wobei ein Abschnitt der mehrschichtigen flexiblen Leiterplatte entsprechend dem Scharnier einen Nichtbiegebereich (NF) und einen Biegebereich (YF) umfasst, in dem die mehrschichtige flexible Leiterplatte gebogen ist, wobei der Biegebereich (YF) einen ersten Biegebereich, der sich von einem Ende des Nichtbiegebereichs (NF) erstreckt, und einen zweiten Biegebereich, der sich von dem anderen Ende des Nichtbiegebereichs (NF) erstreckt, umfasst,
wobei die zumindest eine Bindungsschicht zumindest teilweise auf dem Nichtbiegebereich gebildet ist und wobei die zumindest eine Bindungsschicht nicht auf dem ersten Biegebereich und dem zweiten Biegebereich gebildet ist.

2. Elektronische Vorrichtung nach Anspruch 1, wobei der Nichtbiegebereich flach ist oder eine Krümmung aufweist, die kleiner als diejenige des Biegebereichs ist.

3. Elektronische Vorrichtung nach Anspruch 1 oder 2, wobei die Bindungsschicht nur zwischen zwei Musterschichten unter der Vielzahl von Musterschichten in dem Nichtbiegebereich gebildet ist.

4. Elektronische Vorrichtung nach einem der Ansprüche 1 bis 3, wobei in dem Abschnitt der mehrschichtigen flexiblen Leiterplatte (420) die mehrschichtige flexible Leiterplatte eine Vielzahl von Nichtbiegebereichen umfasst, und
die Bindungsschicht zwischen verschiedenen Musterschichten in zwei von den Nichtbiegebereichen, die zwischen den Biegebereichen positioniert sind, angeordnet ist.

5. Elektronische Vorrichtung nach einem der Ansprüche 1 bis 4, ferner umfassend eine Anzeige (230), die in dem ersten Gehäuse und dem zweiten Gehäuse angeordnet ist,
wobei die Bindungsschicht zwischen den zwei Musterschichten angeordnet ist, die am nächsten zu der Anzeige unter der Vielzahl von Musterschichten in dem Nichtbiegebereich positioniert sind.

6. Elektronische Vorrichtung nach einem der Ansprüche 1 bis 5, wobei der Nichtbiegebereich Folgendes umfasst:
einen ersten Nichtbiegebereich (NF1), wobei zumindest ein Abschnitt in einer Mitte (C) des Faltbereichs positioniert ist; und
einen zweiten (NF2) und einen dritten (NF3) Nichtbiegebereich, die symmetrisch um den ersten Nichtbiegebereich positioniert sind.

7. Elektronische Vorrichtung nach Anspruch 6, wobei die Bindungsschicht, die in dem ersten Nichtbiegebereich gebildet ist, und die Bindungsschicht, die in dem zweiten Nichtbiegebereich gebildet ist, zwischen verschiedenen Musterschichten positioniert sind.

8. Elektronische Vorrichtung nach einem der Ansprüche 1 bis 7, wobei in dem Nichtbiegebereich die Bindungsschicht eine Vielzahl von Bindungsteilen (922a) umfasst, und
die Vielzahl von Bindungsteilen dazu angeordnet ist, in einer Längenrichtung der mehrschichtigen flexiblen Leiterplatte beabstandet zu sein.

9. Elektronische Vorrichtung nach einem der Ansprüche 1 bis 8, wobei die Vielzahl von Musterschichten eine erste Musterschicht (9211), eine zweite Musterschicht (9212) und eine dritte Musterschicht (9213) umfasst, die in einer Höhenrichtung der mehrschichtigen flexiblen Leiterplatte gestapelt sind,
wobei die Bindungsschicht Folgendes umfasst:
eine erste Bindungsschicht (9221), die zwischen der ersten Musterschicht und der zweiten Musterschicht angeordnet ist; und
eine zweite Bindungsschicht (9222), die zwischen der zweiten Musterschicht und der dritten Musterschicht angeordnet ist,
wobei eine Länge der ersten Bindungsschicht länger als diejenige der zweiten Bindungsschicht ist.

10. Elektronische Vorrichtung nach einem der Ansprüche 1 bis 9, wobei in dem Abschnitt der mehrschichtigen flexiblen Leiterplatte (420) die zumindest eine Bindungsschicht nur in einem vorbestimmten Bereich (P1) des Nichtbiegebereichs gebildet ist.

11. Elektronische Vorrichtung nach Anspruch 10, wobei der vorbestimmte Bereich ein Bereich ist, der Reduzierung eines Pfadverlusts erfordert.

12. Elektronische Vorrichtung nach Anspruch 10, wobei der vorbestimmte Bereich ein Bereich ist, in dem ein Hochfrequenz-, HF-Signaldraht angeordnet ist.

13. Elektronische Vorrichtung nach einem der Ansprüche 1 bis 12, wobei zumindest eine von den Musterschichten aus einer Vielzahl von Schichten besteht und eine Schicht, die einen Isolator beinhaltet, und eine Schicht, die ein leitendes Muster beinhaltet, umfasst.

14. Elektronische Vorrichtung nach einem der Ansprüche 1 bis 13, wobei die Bindungsschicht eine vorbestimmte Dicke zwischen zwei von den Musterschichten aufweist und in einer Längenrichtung der mehrschichtigen flexiblen Leiterplatte erstreckt ist.

## Revendications

1. Dispositif électronique (300) comprenant :
un premier boîtier (310) où une première carte de circuit imprimé (350) est disposée ;
un second boîtier (320) où une seconde carte de circuit imprimé (360) est disposée ;
une charnière (390) conçue pour connecter de manière rotative le premier boîtier et le second boîtier l'un par rapport à l'autre ; et
une carte de circuit imprimé souple multicouche (420) conçue pour connecter la première carte de circuit imprimé et la seconde carte de circuit imprimé et disposée à travers une zone de pliage (300A) du dispositif électronique où la charnière est positionnée, dans lequel la carte de circuit imprimé souple multicouche (420) comprend une pluralité de couches de motif (421) empilées dans une direction de hauteur de la carte de circuit imprimé souple multicouche et au moins une couche de liaison (422) conçue pour lier une partie entre au moins deux couches de motif de la pluralité de couches de motif,
dans lequel une partie de la carte de circuit imprimé souple multicouche correspondant à la charnière comprend une zone de non flexion (NF) et une zone de flexion (YF) où la carte de circuit imprimé souple multicouche est pliée, la zone de flexion (YF) comprenant une première zone de flexion s'étendant à partir d'une extrémité de la zone de non flexion (NF) et une seconde zone de flexion s'étendant à partir de l'autre extrémité de la zone de non flexion (NF)
dans lequel l'au moins une couche de liaison est formée au moins partiellement sur la zone de non flexion et dans lequel l'au moins une couche de liaison n'est pas formée sur la première zone de flexion et la seconde zone de flexion.

2. Dispositif électronique de la revendication 1, dans lequel la zone de non flexion est plate ou présente une courbure inférieure à celle de la zone de flexion.

3. Dispositif électronique de la revendication 1 ou 2, dans lequel la couche de liaison est formée uniquement entre deux couches de motif parmi la pluralité de couches de motif dans la zone de non flexion.

4. Dispositif électronique de l'une quelconque des revendications 1 à 3, dans lequel, dans la partie de la carte de circuit imprimé souple multicouche (420), la carte de circuit imprimé souple multicouche comprend une pluralité de zones de non flexion, et
la couche de liaison est disposée entre différentes couches de motif dans deux des zones de non flexion positionnées entre les zones de flexion.

5. Dispositif électronique de l'une quelconque des revendications 1 à 4, comprenant en outre un affichage (230) disposé dans le premier boîtier et le second boîtier,
dans lequel la couche de liaison est disposée entre les deux couches de motif positionnées le plus près de l'affichage parmi la pluralité de couches de motif dans la zone de non flexion.

6. Dispositif électronique de l'une quelconque des revendications 1 à 5, dans lequel la zone de non flexion comprend :
une première zone de non flexion (NF1) dont au moins une partie est positionnée au niveau d'un centre (C) de la zone de pliage ; et
de deuxième (NF2) et troisième (NF3) zones de non flexion positionnées symétriquement par rapport à la première zone de non flexion.

7. Dispositif électronique de la revendication 6, dans lequel la couche de liaison formée dans la première zone de non flexion et la couche de liaison formée dans la deuxième zone de non flexion sont positionnées entre des couches de motif différentes.

8. Dispositif électronique de l'une quelconque des revendications 1 à 7, dans lequel, dans la zone de non flexion, la couche de liaison comprend une pluralité de parties de liaison (922a) et la pluralité de parties de liaison sont disposées pour être espacées dans une direction de longueur de la carte de circuit imprimé souple multicouche.

9. Dispositif électronique de l'une quelconque des revendications 1 à 8, dans lequel la pluralité de couches de motif comprend une première couche de motif (9211), une deuxième couche de motif (9212) et une troisième couche de motif (9213) empilées dans une direction de hauteur de la carte de circuit imprimé souple multicouche, dans lequel la couche de liaison comprend :
une première couche de liaison (9221) disposée entre la première couche de motif et la deuxième couche de motif ; et
une seconde couche de liaison (9222) disposée entre la deuxième couche de motif et la troisième couche de motif, dans lequel une longueur de la première couche de liaison est plus longue que celle de la seconde couche de liaison.

10. Dispositif électronique de l'une quelconque des revendications 1 à 9, dans lequel, dans la partie de la carte de circuit imprimé souple multicouche (420), l'au moins une couche de liaison est formée uniquement dans une zone (P1) prédéterminée de la zone de non flexion.

11. Dispositif électronique de la revendication 10, dans lequel la zone prédéterminée est une zone nécessitant une réduction d'une perte de trajet.

12. Dispositif électronique de la revendication 10, dans lequel la zone prédéterminée est une zone où un fil de signal de radiofréquence, RF, est disposé.

13. Dispositif électronique de l'une quelconque des revendications 1 à 12, dans lequel au moins une des couches de motif est composée d'une pluralité de couches et comprend une couche comprenant un isolant et une couche comprenant un motif conducteur.

14. Dispositif électronique de l'une quelconque des revendications 1 à 13, dans lequel la couche de liaison présente une épaisseur prédéterminée entre deux des couches de motif et s'étend dans une direction de longueur de la carte de circuit imprimé souple multicouche.
